# EUROPEAN PATENT APPLICATION

(11) **EP 4 769 246 A1**
(43) Date of publication of application: **01.07.2026**
(21) Application number: 25216575.8
(22) Date of filing: 18.11.2025
(51) Int. Cl.: G06N 10/70, G06N 10/40

(54) **TECHNOLOGIES FOR CLOSED-LOOP QUBIT CALIBRATION**

(30) Priority: 27.12.2024 US 202419002952
(71) Applicant: Intel Corporation, Santa Clara, CA 95054 (US)
(72) Inventor: SUBRAMANIAN, Sushil, Portland, OR 97229 (US); LEVINGER, Run, Portland, OR 97229 (US); SHUMAKER, Evgeny, 3680304 Nesher (IL)
(74) Representative: HGF

(57) **Abstract**

Technologies for closed-loop calibration of pulses to control spin qubits are disclosed. In an illustrative embodiment, calibration circuitry generates a pulse from a pulse generator. The pulse passes through a variable filter controlled by a filter parameter. The pulse is provided to a qubit, and the qubit is measured. Depending on the measured state of the qubit, the filter parameter can be changed. In this manner, the control pulses can be quickly and continuously calibrated. The calibration approach above offers several advantages. It can be implemented by circuitry close to the physical qubit, reducing opportunities for noise, cross-talk, etc. The calibration approach is scalable, as the calibration can be done quickly and continuously on a given qubit, and the same calibration circuitry can be multiplexed to interface with several qubits. The calibration circuitry can be on an integrated circuit, which can be in a cryogenic stage of the quantum computer.

## Description

### BACKGROUND

Quantum computers promise computational abilities that are not feasible with classical computing. One of many challenges in quantum computing is performing fast, high-fidelity operations on quantum bits (qubits). Depending on a variety of factors, such as manufacturing variations, environmental noise, cross-talk, etc., parameters for pulses to control qubits may vary slightly from qubit to qubit and vary slightly over time. Manual, one-time calibration of qubits does not scale to a large number of qubits or scale over a long period of time.

### BRIEF DESCRIPTION OF THE DRAWINGS

FIGS. 1A-1F illustrate various views of an example quantum dot device, in accordance with one embodiment.
FIG. 2 is a simplified block diagram of at least one embodiment of a quantum compute device.
FIG. 3 is a simplified block diagram of at least one embodiment of a portion of the quantum compute device of FIG. 2.
FIG. 4 is a simplified block diagram of at least one embodiment of an environment that may be established by the quantum compute device of FIG. 2.
FIG. 5 is a simplified diagram of one embodiment of calibration circuitry to calibrate a qubit of the quantum compute device of FIG. 2.
FIG. 6 is a simplified diagram of one embodiment of calibration circuitry to calibrate a qubit of the quantum compute device of FIG. 2.
FIG. 7 is a simplified diagram of one embodiment of a channel that may carry a signal to a qubit of the quantum compute device of FIG. 2.
FIG. 8 is a plot showing an ideal voltage pulse and a voltage pulse after one embodiment of a channel.
FIG. 9 is a plot showing a filter parameter as a function of time that may be determined by the calibration circuitry of FIG. 5.
FIG. 10 is a plot showing average (1-fidelity) measurement as a function of calibration cycles.
FIG. 11 is a simplified flow diagram of at least one embodiment of a method for calibrating control pulses that may be executed by the quantum compute device of FIG. 2.
FIG. 12 is a simplified flow diagram of at least one embodiment of a method for controlling qubits and calibrating control pulses that may be executed by the quantum compute device of FIG. 2.
FIG. 13 is a top view of a wafer and dies, in accordance with any of the embodiments disclosed herein.
FIG. 14 is a cross-sectional side view of an integrated circuit, in accordance with any of the embodiments disclosed herein.
FIGS. 15A-15D are perspective views of example planar, gate-all-around, and stacked gate-all-around transistors.
FIG. 16 is a cross-sectional side view of an integrated circuit device assembly, in accordance with any of the embodiments disclosed herein.
FIG. 17 is a block diagram of an example electrical device, in accordance with any of the embodiments disclosed herein.

### DETAILED DESCRIPTION

Aspects of the present disclosure include a quantum compute device with a quantum processor. In use, the quantum processor has several spin qubits defined in it. Various techniques described below can be used to calibrate pulses to control the spin qubits. In one embodiment, control circuitry can continuously or continually calibrate pulses. To do so, in one embodiment, a pulse is generated based on a filter parameter, such as an amount of gain for the pulse. The pulse is applied to the qubit being calibrated, and then the qubit is measured. The value of the filter parameter is updated based on the measurement of the qubit. The calibration process can then be repeated, generating another pulse based on the updated filter parameter. Over time, the calibration process leads to a filter parameter that generates a well-calibrated control pulse.

The calibration approach described above offers several advantages. In some embodiments, it can be implemented by circuitry close to the physical qubit, reducing opportunities for noise, cross-talk, etc. In other embodiments, it can be implemented by circuitry that is far away from the physical qubits, offering flexibility. The calibration approach is scalable, as the calibration can be done quickly and continuously on a given qubit, and the same calibration circuitry can be multiplexed to interface with several qubits. The calibration approach can be used for any suitable filter or filter parameter, such as gain, frequency of a pulse, pulse length, a parameter for a finite impulse response (FIR) filter, a parameter for an infinite impulse response (IIR) filter, parameters for qubits nearby being driven at the same time, etc. In some cases, the calibration of control pulses for qubits can be done while the quantum processor is in operation. Since the error on a control pulse converges to a desired value automatically within the loop, the system is inherently scalable to as large a number of pulse generators as required, while allowing for different adjustments depending on their respective imperfections. The scalability is further improved in embodiments with the entire correction technique implemented as a cryo-CMOS integrated circuit, thereby providing local correction within the cryogenic refrigerator, reducing cabling delays and other imperfections due to signals transmitted outside the cryogenic refrigerator. The approach described herein acts as a phase-locked loop (PLL) to continuously or continually correct any error on the gate pulses, similar to a PLL for a clock timer.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner.

"Connected" may indicate elements are in direct physical or electrical contact with each other and "coupled" may indicate elements cooperate or interact with each other, but they may or may not be in direct physical or electrical contact. Furthermore, the terms "comprising," "including," "having," and the like, as used with respect to embodiments of the present disclosure, are synonymous.

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components. As used herein, the term "adjacent" refers to layers or components that are in physical contact with each other. That is, there is no layer or component between the stated adjacent layers or components. For example, a layer X that is adjacent to a layer Y refers to a layer that is in physical contact with layer Y.As used herein, the phrase "electrically coupled" refers to the presence of one or more electrically conductive paths between components that are recited as being electrically coupled.

Certain terminology may also be used herein for the purpose of reference only, and thus are not intended to be limiting. For example, terms such as "upper," "lower," "above," "below," "bottom," and "top" refer to directions in the Figures to which reference is made. Terms such as "front," "back," "rear," and "side" describe the orientation and/or location of layers, components, portions of components, etc., within a consistent but arbitrary frame of reference, which is made clear by reference to the text and the associated Figures describing the layers, component, portions of components, etc. under discussion. Such terminology may include the words specifically mentioned above, derivatives thereof, and words of similar import.

As used herein, the term "integrated circuit component" refers to a packaged or unpacked integrated circuit product. A packaged integrated circuit component comprises one or more integrated circuit dies mounted on a package substrate with the integrated circuit dies and package substrate encapsulated in a casing material, such as metal, plastic, glass, or ceramic. In one example, a packaged integrated circuit component contains one or more processor units mounted on a substrate with an exterior surface of the substrate comprising a solder ball grid array (BGA). In one example of an unpackaged integrated circuit component, a single monolithic integrated circuit die comprises solder bumps attached to contacts on the die. The solder bumps allow the die to be directly attached to a printed circuit board. An integrated circuit component can comprise one or more of any computing system component described or referenced herein or any other computing system component, such as a processor unit (e.g., system-on-a-chip (SoC), processor core, graphics processor unit (GPU), accelerator, chipset processor), I/O controller, memory, or network interface controller.

As used herein, the term "electronic component" can refer to an active electronic component (e.g., processing unit, memory, storage device, transistor) or a passive electronic component (e.g., resistor, inductor, capacitor).

As used herein, the terms "operating," "executing," or "running" as they pertain to software or firmware in relation to a system, device, platform, or resource are used interchangeably and can refer to software or firmware stored in one or more computer-readable storage media accessible by the system, device, platform or resource, even though the software or firmware instructions are not actively being executed by the system, device, platform, or resource.

Reference is now made to the drawings, which are not necessarily drawn to scale, wherein similar or the same numbers may be used to designate the same or similar parts in different figures. The use of similar or the same numbers in different figures does not mean all figures including similar or the same numbers constitute a single or same embodiment. Like numerals having different letter suffixes may represent different instances of similar components. The drawings illustrate generally, by way of example, but not by way of limitation, various embodiments discussed in the present document.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

As used in this application and the claims, a list of items joined by the term "and/or" can mean any combination of the listed items. For example, the phrase "A, B, and/or C" can mean A; B; C; A and B; A and C; B and C; or A, B and C. As used in this application and the claims, a list of items joined by the term "at least one of" can mean any combination of the listed terms. For example, the phrase "at least one of A, B, or C" can mean A; B; C; A and B; A and C; B and C; or A, B, and C. Moreover, as used in this application and the claims, a list of items joined by the term "one or more of" can mean any combination of the listed terms. For example, the phrase "one or more of A, B, and C" can mean A; B; C; A and B; A and C; B and C; or A, B, and C.

As used in this application and the claims, the phrase "individual of" or "respective of" followed by a list of items recited or stated as having a trait, feature, etc., means that all of the items in the list possess the stated or recited trait, feature, etc. For example, the phrase "individual of A, B, or C, comprise a sidewall" or "respective of A, B, or C, comprise a sidewall" means that A comprises a sidewall, B comprises a sidewall, and C comprises a sidewall.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

A quantum computer uses quantum-mechanical phenomena such as superposition and entanglement to perform computations, simulations, or other functions. In contrast to digital computers, which store data in one of two definite states (0 or 1), quantum computation uses quantum bits (qubits), which can be in superpositions of states. Qubits may be implemented using physically distinguishable quantum states of elementary particles such as electrons and photons. For example, the polarization of a photon may be used where the two states are vertical polarization and horizontal polarization. Similarly, the spin of an electron may have distinguishable states such as "up spin" and "down spin." Qubits in quantum mechanical systems can be in a superposition of both states at the same time, a trait that is unique and fundamental to quantum computing.

Quantum computing systems execute algorithms containing quantum logic operations performed on qubits. In some cases, the result of the algorithm is not deterministic. The quantum algorithm may be repeated many times in order to determine a statistical distribution of results or in order to have a high likelihood of finding the correct answer. In some cases, a classical algorithm may be used to check if the quantum computer determined the correct result.

Qubits have been implemented using a variety of different technologies which are capable of manipulating and reading quantum states. These include but are not limited to quantum dot devices (single-qubit spin based, multi-qubit spin based, spatial based, exchange-coupling based, etc.), trapped-ion devices, superconducting quantum computers, optical lattices, nuclear magnetic resonance computers, solid-state NMR Kane quantum devices, electrons-on-helium quantum computers, cavity quantum electrodynamics (CQED) devices, molecular magnet computers, and fullerene-based ESR quantum computers, to name a few. Thus, while a quantum dot device is described below in relation to certain embodiments of the invention, the underlying principles of the invention may be employed in combination with any type of quantum computer, including, but not limited to, those listed above. The particular physical implementation used for qubits is not necessarily required for the embodiments of the invention described herein.

Quantum dots are small semiconductor particles, typically a few nanometers in size. Because of this small size, quantum dots operate according to the rules of quantum mechanics, having optical and electronic properties which differ from macroscopic entities. Quantum dots are sometimes referred to as "artificial atoms" to connote the fact that a quantum dot is a single object with discrete, bound electronic states, as is the case with atoms or molecules.

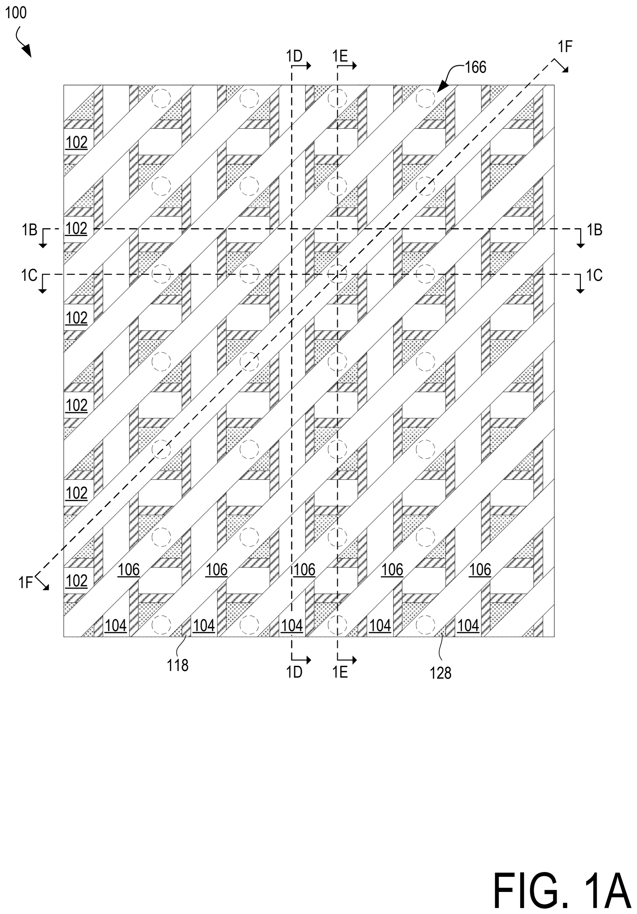

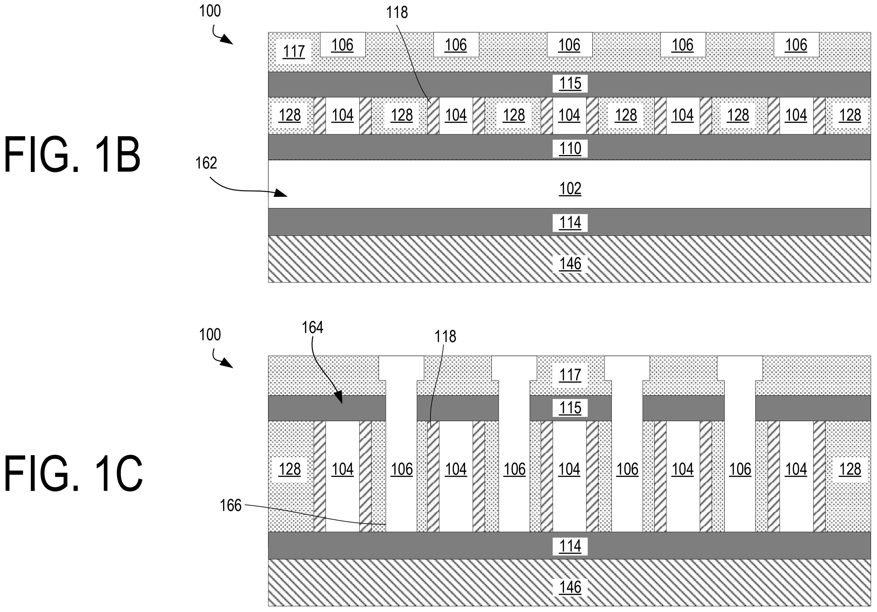

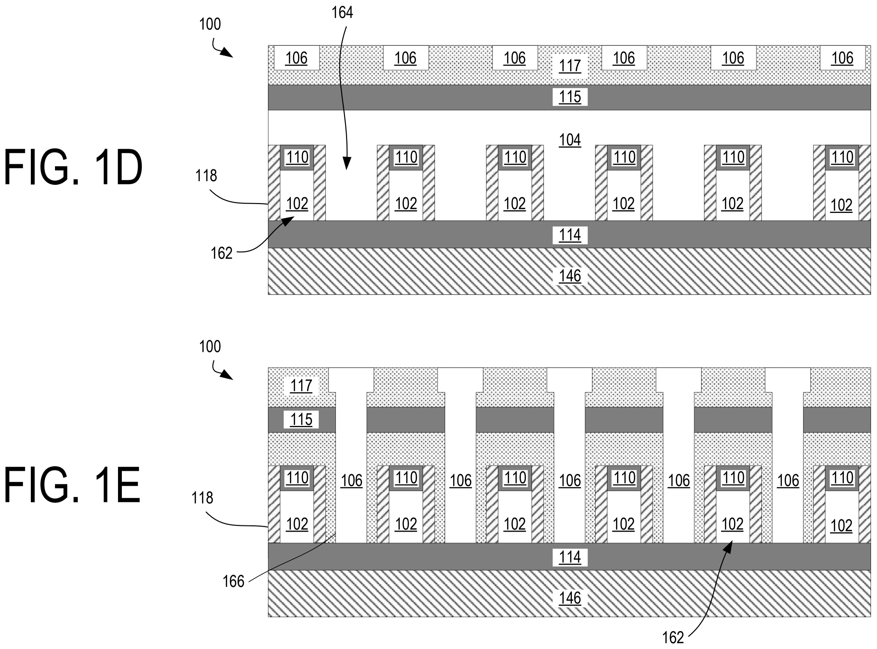

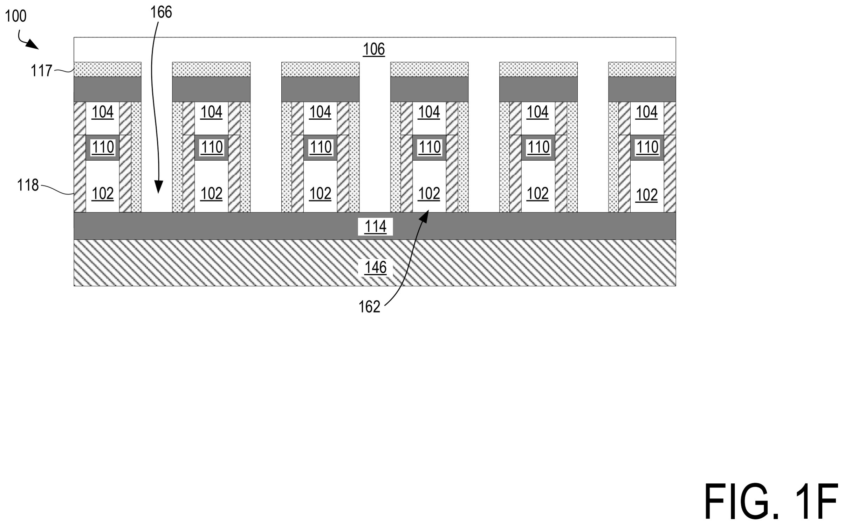

Figures 1A-1F are various views of a quantum dot device 100, which may be used with embodiments of the invention described below. Figure 1A is a top view of a portion of the quantum dot device 100 with some of the materials removed so that the first gate lines 102, the second gate lines 104, and the third gate lines 106 are visible. Although many of the drawings and description herein may refer to a particular set of lines or gates as "barrier" or "quantum dot" lines or gates, respectively, this is simply for ease of discussion, and in other embodiments, the role of "barrier" and "quantum dot" lines and gates may be switched (e.g., barrier gates may instead act as quantum dot gates, and vice versa). Figures 1B-1F are side cross-sectional views of the quantum dot device 100 of Figure 1A; in particular, Figure 1B is a view through the section B-B of Figure 1A, Figure 1C is a view through the section C-C of Figure 1A, Figure 1D is a view through the section D-D of Figure 1A, Figure 1E is a view through the section E-E of Figure 1A, and Figure 1F is a view through the section F-F of Figure 1A.

The quantum dot device 100 may include or be embodied as any suitable material, such as a die with a silicon substrate and various components patterned or built on the silicon substrate. The quantum dot device 100 of Figure 1 may be operated in any of a number of ways. For example, in some embodiments, electrical signals such as voltages, currents, radio frequency (RF), and/or microwave signals, may be provided to one or more first gate line 102, second gate line 104, and/or third gate line 106 to cause a quantum dot (e.g., an electron spin-based quantum dot or a hole spin-based quantum dot) to form in a quantum well stack 146 under a third gate 166 of a third gate line 106. Electrical signals provided to a third gate line 106 may control the electrical potential of a quantum well under the third gates 166 of that third gate line 106, while electrical signals provided to a first gate line 102 (and/or a second gate line 104) may control the potential energy barrier under the first gates 162 of that first gate line 102 (and/or the second gates 164 of that second gate line 104) between adjacent quantum wells. Quantum interactions between quantum dots in different quantum wells in the quantum well stack 146 (e.g., under different quantum dot gates) may be controlled in part by the potential energy barrier provided by the barrier potentials imposed between them (e.g., by intervening barrier gates).

Generally, the quantum dot devices 100 disclosed herein may further include a source of magnetic fields (not shown) that may be used to create an energy difference in the states of a quantum dot (e.g., the spin states of an electron spin-based quantum dot) that are normally degenerate, and the states of the quantum dots (e.g., the spin states) may be manipulated by applying electromagnetic energy to the gates lines to create quantum bits capable of computation. The source of magnetic fields may be one or more magnet lines. Thus, the quantum dot devices 100 disclosed herein may, through controlled application of electromagnetic energy, be able to manipulate the position, number, and quantum state (e.g., spin) of quantum dots in the quantum well stack 146. Additionally or alternatively, in some embodiments, some or all of the interactions between qubits may be exchange interactions.

In the quantum dot device 100 of Figure 1, a gate dielectric 114 may be disposed on a quantum well stack 146. A quantum well stack 146 may include at least one quantum well layer (not shown in Figure 1) in which quantum dots may be localized during operation of the quantum dot device 100. The quantum well stack 146 may include, e.g., one or more alternating layers of silicon and silicon-germanium. The gate dielectric 114 may be any suitable material, such as a high-k material. Multiple parallel first gate lines 102 may be disposed on the gate dielectric 114, and spacer material 118 may be disposed on side faces of the first gate lines 102. In some embodiments, a patterned hardmask 110 may be disposed on the first gate lines 102 (with the pattern corresponding to the pattern of the first gate lines 102), and the spacer material 118 may extend up the sides of the hardmask 110, as shown. The first gate lines 102 may each be a first gate 162. Different ones of the first gate lines 102 may be electrically controlled in any desired combination (e.g., each first gate line 102 may be separately electrically controlled, or some or all the first gate lines 102 may be shorted together in one or more groups, as desired).

Multiple parallel second gate lines 104 may be disposed over and between the first gate lines 102. As illustrated in Figure 1, the second gate lines 104 may be arranged perpendicular to the first gate lines 102. The second gate lines 104 may extend over the hardmask 110, and may include second gates 164 that extend down toward the quantum well stack 146 and contact the gate dielectric 114 between adjacent ones of the first gate lines 102, as illustrated in Figure 1D. In some embodiments, the second gates 164 may fill the area between adjacent ones of the first gate lines 102/spacer material 118 structures; in other embodiments, an insulating material (not shown) may be present between the first gate lines 102/spacer material 118 structures and the proximate second gates 164. In some embodiments, spacer material 118 may be disposed on side faces of the second gate lines 104; in other embodiments, no spacer material 118 may be disposed on side faces of the second gate lines 104. In some embodiments, a hardmask 115 may be disposed above the second gate lines 104. Multiple ones of the second gates 164 of a second gate line 104 are electrically continuous (due to the shared conductive material of the second gate line 104 over the hardmask 110). Different ones of the second gate lines 104 may be electrically controlled in any desired combination (e.g., each second gate line 104 may be separately electrically controlled, or some or all the second gate lines 104 may be shorted together in one or more groups, as desired). Together, the first gate lines 102 and the second gate lines 104 may form a grid, as depicted in Figure 1.

Multiple parallel third gate lines 106 may be disposed over and between the first gate lines 102 and the second gate lines 104. As illustrated in Figure 1, the third gate lines 106 may be arranged diagonal to the first gate lines 102, and diagonal to the second gate lines 104. In particular, the third gate lines 106 may be arranged diagonally over the openings in the grid formed by the first gate lines 102 and the second gate lines 104. The third gate lines 106 may include third gates 166 that extend down to the gate dielectric 114 in the openings in the grid formed by the first gate lines 102 and the second gate lines 104; thus, each third gate 166 may be bordered by two different first gate lines 102 and two different second gate lines 104. In some embodiments, the third gates 166 may be bordered by insulating material 128; in other embodiments, the third gates 166 may fill the openings in the grid (e.g., contacting the spacer material 118 disposed on side faces of the adjacent first gate lines 102 and the second gate lines 104, not shown). Additional insulating material 117 may be disposed on and/or around the third gate lines 106. Multiple ones of the third gates 166 of a third gate line 106 are electrically continuous (due to the shared conductive material of the third gate line 106 over the first gate lines 102 and the second gate lines 104). Different ones of the third gate lines 106 may be electrically controlled in any desired combination (e.g., each third gate line 106 may be separately electrically controlled, or some or all the third gate lines 106 may be shorted together in one or more groups, as desired).

Although Figures 1A-F illustrate a particular number of first gate lines 102, second gate lines 104, and third gate lines 106, this is simply for illustrative purposes, and any number of first gate lines 102, second gate lines 104, and third gate lines 106 may be included in a quantum dot device 100. Other examples of arrangements of first gate lines 102, second gate lines 104, and third gate lines 106 are possible. Electrical interconnects (e.g., vias and conductive lines) may contact the first gate lines 102, second gate lines 104, and third gate lines 106 in any desired manner.

Not illustrated in Figure 1 are accumulation regions that may be electrically coupled to the quantum well layer of the quantum well stack 146 (e.g., laterally proximate to the quantum well layer). The accumulation regions may be spaced apart from the gate lines by a thin layer of an intervening dielectric material. The accumulation regions may be regions in which carriers accumulate (e.g., due to doping, or due to the presence of large electrodes that pull carriers into the quantum well layer), and may serve as reservoirs of carriers that can be selectively drawn into the areas of the quantum well layer under the third gates 166 (e.g., by controlling the voltages on the quantum dot gates, the first gates 162, and the second gates 164) to form carrier-based quantum dots (e.g., electron or hole quantum dots, including a single charge carrier, multiple charge carriers, or no charge carriers). In other embodiments, a quantum dot device 100 may not include lateral accumulation regions, but may instead include doped layers within the quantum well stack 146. These doped layers may provide the carriers to the quantum well layer. Any combination of accumulation regions (e.g., doped or non-doped) or doped layers in a quantum well stack 146 may be used in any of the embodiments of the quantum dot devices 100 disclosed herein.

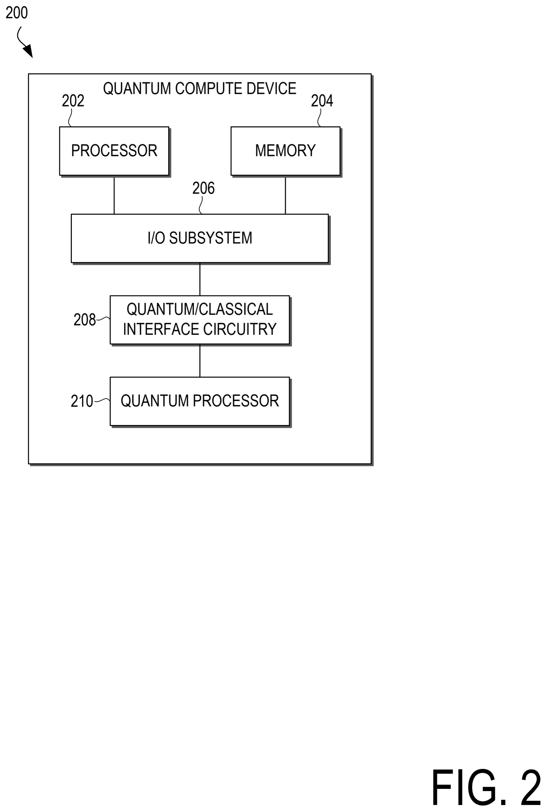

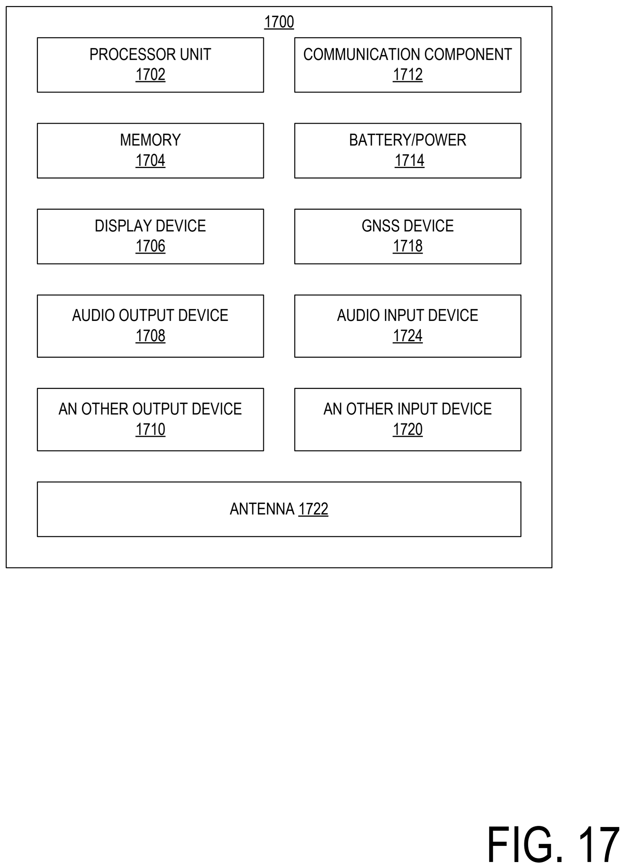

Referring now to FIG. 2, a simplified block diagram of a quantum compute device 200 is shown. In some embodiments, the quantum compute device 200 may include the quantum dot devices 100 described above in regard to FIGS. 1A-1F. The quantum compute device 200 may be embodied as or included in any type of compute device. For example, the quantum compute device 200 may include or otherwise be included in, without limitation, a server computer, an embedded computing system, a System-on-a-Chip (SoC), a multiprocessor system, a processor-based system, a consumer electronic device, a desktop computer, a laptop computer, a network device, a networked computer, a distributed computing system, and/or any other computing device. The illustrative quantum compute device 200 includes a processor 202, a memory 204, an input/output (I/O) subsystem 206, a quantum/classical interface circuitry 208, and a quantum processor 210. In some embodiments, one or more of the illustrative components of the quantum compute device 200 may be incorporated in, or otherwise form a portion of, another component. For example, the memory 204, or portions thereof, may be incorporated in the processor 202 in some embodiments. In some embodiments, the quantum compute device 200 may be embodied as the electrical device 1700 described below in regard to FIG. 17 or may include any suitable component of the electrical device 1700.

In some embodiments, the quantum compute device 200 may be located in a data center with other compute devices, such as an enterprise data center (e.g., a data center owned and operated by a company and typically located on company premises), managed services data center (e.g., a data center managed by a third party on behalf of a company), a colocated data center (e.g., a data center in which data center infrastructure is provided by the data center host and a company provides and manages their own data center components (servers, etc.)), cloud data center (e.g., a data center operated by a cloud services provider that host companies applications and data), and an edge data center (e.g., a data center, typically having a smaller footprint than other data center types, located close to the geographic area that it serves), a micro data center, etc. In some embodiments, the quantum compute device 200 may receive jobs over a network (such as the Internet) to perform on the quantum processor 210. The quantum compute device 200 may perform the jobs on the quantum processor 210 and send the results back to the requesting device.

The processor 202 may be embodied as any type of processor capable of performing the functions described herein. For example, the processor 202 may be embodied as a single or multi-core processor(s), a single or multi-socket processor, a digital signal processor, a graphics processor, a neural network compute engine, an image processor, a microcontroller, or other processor or processing/controlling circuit. The processor 202 may include multiple processor cores. In some embodiments, the processor 202 supports quantum extensions to an existing ISA of the processor/core, allowing instructions that interface with the quantum/classical interface circuitry 208 and the quantum processor 210.

The memory 204 may be embodied as any type of volatile or non-volatile memory or data storage capable of performing the functions described herein. In operation, the memory 204 may store various data and software used during operation of the quantum compute device 200, such as operating systems, applications, programs, libraries, and drivers. The memory 204 is communicatively coupled to the processor 202 via the I/O subsystem 206, which may be embodied as circuitry and/or components to facilitate input/output operations with the processor 202, the memory 204, and other components of the quantum compute device 200. For example, the I/O subsystem 206 may be embodied as, or otherwise include, memory controller hubs, input/output control hubs, firmware devices, communication links (e.g., point-to-point links, bus links, wires, cables, light guides, printed circuit board traces, etc.) and/or other components and subsystems to facilitate the input/output operations. The I/O subsystem 206 may connect various internal and external components of the quantum compute device 200 to each other with use of any suitable connector, interconnect, bus, protocol, etc., such as an SoC fabric, PCIe^{®}, USB2, USB3, USB4, NVMe^{®}, Thunderbolt^{®}, Compute Express Link (CXL), and/or the like. In some embodiments, the I/O subsystem 206 may form a portion of a system-on-a-chip (SoC) and be incorporated, along with the processor 202 and the memory 204 and other components of the quantum compute device 200 on a single integrated circuit chip.

The quantum/classical interface circuitry 208 is configured to interface with both classical components of the quantum compute device 200, such as the processor 202 and memory 204, as well as the quantum processor 210. The quantum/classical interface circuitry 208 may include a variety of analog or digital circuitry, such as analog-to-digital converters, digital-to-analog converters, high gain amplifiers, low noise amplifiers, cryogenic amplifiers, field-programmable gate arrays (FPGAs), classical processors, application-specific integrated circuits (ASICs), signal conditioning circuitry, etc. In some embodiments, some or all of the quantum/classical interface circuitry 208 may be embodied as or otherwise included in other components of the quantum compute device 200, such the processor 202 and memory 204. In some embodiments, some or all of the quantum/classical interface circuitry 208 may be inside of a refrigerator, such as a dilution refrigerator, a magnetic refrigerator, a helium-4 and/or helium-3 refrigerator, etc. Some or all of the components of the quantum/classical interface circuitry 208 may be at any suitable temperature, such as 10 millikelvin, 100 millikelvin, 4 Kelvin, 20 Kelvin, 77 Kelvin, room temperature or above, or anywhere in between.

The quantum processor 210 is configured to operate one or more qubits. The qubits may be any suitable type of qubit, such as a quantum dot spin qubit described above in regard to FIGS. 1A-1F. In other embodiments, the qubits may be, e.g., charge qubits, transmon qubits, microwave qubits, superconducting qubits, or any other suitable type of qubits. The quantum processor 210 may include any suitable number of physical or logical qubits, such as 1-10⁶. In the illustrative embodiment, some or all of the quantum processor 210 is in a refrigerator such as a dilution refrigerator. In particular, in the illustrative embodiment, the qubits are held at a temperature of about 10 millikelvin. In other embodiments, the qubits may be held at any suitable temperature, such as 1-100 millikelvin or higher, depending on the temperature sensitivity of the particular qubit in use.

The quantum processor 210 may be able to control the various qubits in various ways, such as by performing single-qubit gates, two-qubit gates, three-qubit gates, error correction operations, transferring a state from one type of qubit to another, measuring some, any, or all of the qubits, initializing some, any, or all of the qubits, etc.

The quantum compute device 200 may include additional components not shown in FIG. 2, such as one or more data storage devices, a network interface controller, one or more peripheral devices, etc.

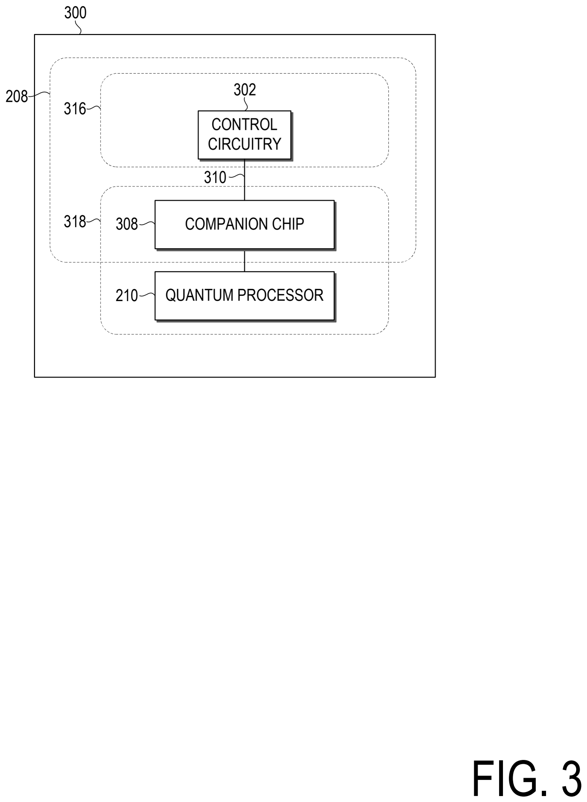

Referring now to FIG. 3, in one embodiment, the quantum processor 210 and some or all of the quantum/classical interface circuitry 208 may be in a cryogenic refrigerator 300. The quantum/classical interface circuitry 208 includes control circuitry 302 that can interface with a companion chip 308. The control circuitry 302 may be connected to the companion chip 308 by one or more wires 310. The wires 310 may be embodied as one or more cables, buses, twisted wire pairs, etc.

In the illustrative embodiment, the control circuitry 302 may be in a first stage 316 of the cryogenic refrigerator 300, and the companion chip 308 and the quantum processor 210 may be in a second stage 318 of the cryogenic refrigerator 300. In some embodiments, some or all of the control circuitry 302 may be external to the cryogenic refrigerator 300. In the illustrative embodiment, the first stage 316 is held at a temperature of about 4 Kelvin, and the second stage 318 is held at a temperature of about 20 millikelvin. In other embodiments, the first stage 316 may be held at, e.g., 1-77 Kelvin, and the second stage 318 may be held at, e.g., 10-100 millikelvin. In some embodiments, the various components of FIG. 3 may be in different stages than that shown in FIG. 3 and/or the refrigerator 300 may include additional stages, such as one or more stages at a higher or lower temperature than the first stage 316 and/or the second stage 318. The cryogenic refrigerator 300 may be any suitable refrigerator with active or passive cooling, such as a dilution refrigerator, a magnetic refrigerator, a helium-4 and/or helium-3 refrigerator, etc.

In use and as described in more detail below, the control circuitry 302 receives instructions from another component of the quantum compute device 200 (e.g., from the processor 202 or the memory 204). The instructions may be digital instructions, such as read from or write to memory, read from or write to a register, conditional branches, etc. The instructions may also be analog instructions, such as an instruction to generate or receive an analog pulse, set an analog voltage on a qubit, set a digital voltage on a multiplexer that selects a qubit, etc. The control circuitry 302 may send and receive digital and/or analog signals to the companion chip 308. Signals for multiple qubits may be sent on the wires 310 from the control circuitry 302 to the companion chip 308, and the companion chip 308 may demultiplex signals from the control circuitry 302, such as by using frequency multiplexing, temporal multiplexing, etc. As such, the control circuitry 302 may send and receive analog signals to a relatively large number of qubits over a relatively small number of wires 310. For example, for each wire 310 carrying analog signals to and from the control circuitry 302, the control circuitry 302 may control 2-100 qubits. Additionally or alternatively, in some embodiments, the control circuitry 302 may send and receive analog and/or digital signals directly to or from the quantum processor 210, without necessarily going through the companion chip 308.

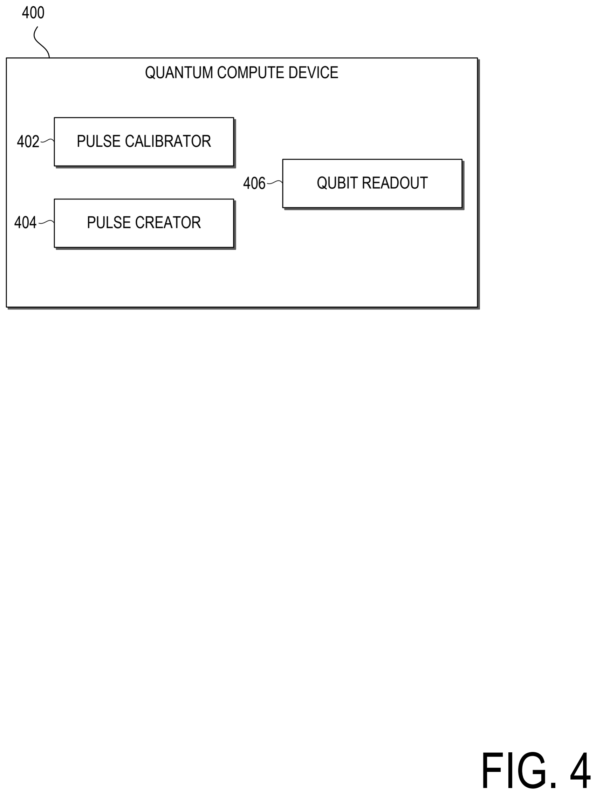

Referring now to FIG. 4, in an illustrative embodiment, the quantum compute device 200 establishes an environment 400 during operation. The illustrative environment 400 includes a pulse calibrator 402, a pulse creator 404, and qubit readout block. The various modules of the environment 400 may be embodied as hardware, software, firmware, or a combination thereof. For example, the various modules, logic, and other components of the environment 400 may form a portion of, or otherwise be established by, the quantum/classical interface circuitry 208, the control circuitry 302, processor 202, the memory 204, data storage, and/or other hardware components of the quantum compute device 200. As such, in some embodiments, one or more of the modules of the environment 400 may be embodied as circuitry or collection of electrical devices (e.g., pulse calibrator circuitry, pulse creator circuitry, qubit readout circuitry, etc.). It should be appreciated that, in such embodiments, one or more of the circuits (e.g., the pulse calibrator circuitry, the pulse creator circuitry, the qubit readout circuitry, etc.) may form a portion of one or more of the processor 202, the memory 204, the data storage, and/or other components of the quantum compute device 200. For example, in some embodiments, some or all of the modules may be embodied as the quantum/classical interface circuitry 208, the control circuitry 302, the processor 202, the memory 204, and/or data storage storing instructions to be executed by the quantum/classical interface circuitry 208, the control circuitry 302, and/or the processor 202. Additionally, in some embodiments, one or more of the illustrative modules may form a portion of another module and/or one or more of the illustrative modules may be independent of one another. Further, in some embodiments, one or more of the modules of the environment 400 may be embodied as virtualized hardware components or emulated architecture, which may be established and maintained by the quantum/classical interface circuitry 208, the control circuitry 302, the processor 202 and/or other components of the quantum compute device 200. It should be appreciated that some of the functionality of one or more of the modules of the environment 400 may require a hardware implementation, in which case embodiments of modules that implement such functionality will be embodied at least partially as hardware.

The pulse calibrator 402, which may be embodied as hardware, firmware, software, virtualized hardware, emulated architecture, and/or a combination thereof as discussed above, is configured to calibrate pulses to be applied to qubits of the quantum processor 210. In use, pulses, such as voltage and/or RF pulses, may be sent to various gates on the quantum processor, such as the various barrier gates and plunger gates, which may be embodied as gates lines 102, 104, 106 described above. In an illustrative embodiment, the voltage pulses may be generated as square voltage pulses on various gates. Additionally or alternatively, voltage pulses may be other shapes, such as trapezoid, triangle, gaussian, sinusoid, or other arbitrary shape. A sequence of voltage pulses may be characterized by a pulse width, which refers to the width of each pulse in a series, and the idle time, which refers to the time between pulses. In an illustrative embodiment, the pulse width is 5 nanoseconds, and the pulse idle time is 5 nanoseconds. Various factors may be used to determine the pulse width and pulse idle time, such as the analog bandwidth available, the coherence time of the qubits, the interaction rate of the qubits, etc. In general, the pulse width and/or pulse idle time may be any suitable value, such as 0.1-100 nanoseconds or up to 10 microseconds or longer.

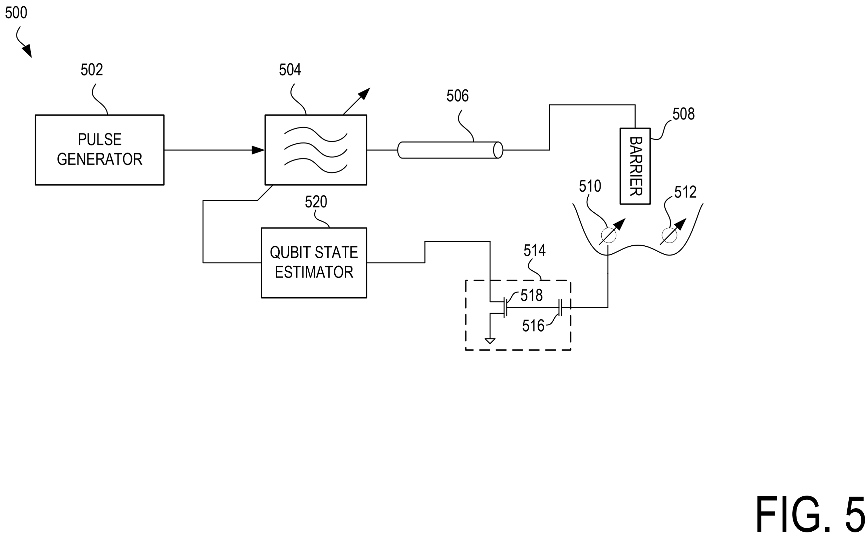

Any pulse that is generated will be limited by the analog bandwidth of the system. For example, in one embodiment, the pulse width and pulse idle time may be 5 nanoseconds, and the analog bandwidth of the system from where the pulses are generated to the gates where they are applied may be, e.g., 200 megahertz. As a result of the limited bandwidth, square wave pulses will be rounded off and will not return to zero within 5 nanoseconds. Additionally, other linear and nonlinear effects may distort the pulses, as described in more detail below in regard to FIGS. 5-8.

The pulse calibrator 402 is configured to perform a calibration at any suitable time, such as every time the quantum compute device 200 is booted up, any time the quantum processor 210 is cooled down to operating temperatures, after a certain period of time has passed since the last calibration, after noise measurements increase past a threshold, etc. In some embodiments, the pulse amplitudes may be calibrated using various other measured or calculated parameters, without performing an explicit calibration.

The pulse calibrator may be embodied as or otherwise interface with the calibration circuitry 500, described in more detail below in regard to FIG. 5.

To perform a calibration, the pulse calibrator 402 determines a control gain parameter K. The control gain parameter may depend on various factors, such as the parameter being tuned (e.g., amplitude, duration, frequency, parameter for an FIR, parameter for an IIR, etc.), the current error for gate operations corresponding to a pulse with the current pulse parameter, an amount of time since calibration, the parameter used on a previous calibration, etc.

The pulse calibrator 402 then determines an initial filter parameter. In some embodiments, the initial filter parameter may be determined based on factors such as the parameter being tuned (e.g., amplitude, duration, frequency, parameter for an FIR, parameter for an IIR, etc.). After an initial calibration cycle, the filter parameter may be stored in a register or other memory or storage location associated with the qubit being calibrated. The filter parameter that was determined from a previous calibration may be accessed to determine the initial filter parameter. The pulse calibrator 402 uses the pulse creator 404 to generate a pulse based on the filter parameter.

The pulse is then provided to the qubit. In an illustrative embodiment, the pulse is a voltage provided to a barrier gate, and the pulse causes an exchange interaction between the qubits. In other embodiments, the pulse may be, e.g., an RF pulse provided to a qubit to change the spin state of the qubit. The qubit readout 406 is then used to determine the state of the qubit.

The pulse calibrator 402 then updates the filter parameter based on the state of the qubit. In an illustrative embodiment, the filter parameter is updated using the formula *Gₙ = KQ+Gₙ₋₁,* where *K* is the control gain parameter, *Q* represents the measurement of the state of the qubit (e.g., *Q* = -0.5 if the qubit is a "0," and *Q =* 0.5 if the qubit is a "1"), and *G*_{*n*-1} is the previous value of the filter parameter.

The pulse calibrator 402 may repeat the calibration loop until calibration is complete. For example, the pulse calibrator 402 may determine whether an amount of phase error is below a threshold, compare an error rate between two different sets of correction values, and/or the like. When the calibration process is complete, the pulse calibrator 402 saves the filter parameter.

The pulse creator 404, which may be embodied as hardware, firmware, software, virtualized hardware, emulated architecture, and/or a combination thereof as discussed above, is configured to create pulses to be sent to the gates of the quantum processor 210 to control the qubits. In the illustrative embodiment, the pulse creator 404 uses the filter parameters determined by the pulse calibrator 402.

The qubit readout 406, which may be embodied as hardware, firmware, software, virtualized hardware, emulated architecture, and/or a combination thereof as discussed above, is configured to perform readout operations on one or more qubits of the quantum processor 210. In an illustrative embodiment, the qubit is read by being coupled to a single-electron transistor 518. As used herein, a single-electron transistor includes few-electron transistors and does not necessarily operate in the single-electron regime unless explicitly stated otherwise, despite the name. The state of the qubit can be read using an Elzerman readout. When the spin qubit is in a spin-up state, the electron that forms the spin qubit can couple to a quantum dot of the single-electron transistor, changing the effective resistance of the single-electron transistor.

Referring now to FIG. 5, in one embodiment, calibration circuitry 500 includes a pulse generator 502, a filter 504, and a channel 506. The channel 506 is connected to a barrier gate 508. The barrier gate 508 controls a barrier between a first spin qubit 510 and a second spin qubit 512. Measurement circuitry 514 is coupled to the qubit 510. The measurement circuitry 514 may include a capacitor 516 and a single-electron transistor 518. An output of the measurement circuitry 514 is provided to qubit state estimator 520, which provides a parameter to the filter 504 based on the measured qubit state.

In use, the qubits 510 are initialized to a known value. The pulse generator 502 generates a pulse, and the filter 504 filters the pulse. The pulse generator 502 may generate any suitable pulse, such as a square voltage pulse, an RF pulse, etc. The filter 504 may apply any suitable filtering, such as a variable gain (which may include a variable attenuation), a finite impulse response (FIR) filter, an infinite impulse response (IIR) filter, etc. In some embodiments, the filter parameter for controlling the pulse may be provided to the pulse generator 502, and the pulse generator 502 may use the filter parameter to generate the pulse. For example, in some embodiments, the filter parameter may tune the frequency of an RF pulse being created. The term "filter parameter" may be used to describe a parameter used to control a pulse generator 502 in this manner, even if an explicit filter is not used.

After the filter 504, the pulse passes through the channel 506. The channel 506 may be any suitable linear or non-linear channel. The pulse is then provided to the barrier gate 508, which controls an interaction between qubits 510, 512.

After the interaction between the qubits 510, 512 due to the pulse, the measurement circuitry 514 performs a measurement on the qubit 510. In an illustrative embodiment, the qubit 510 is coupled to a single-electron transistor 518. As used herein, a single-electron transistor includes few-electron transistors and does not necessarily operate in the single-electron regime unless explicitly stated otherwise, despite the name. The state of the qubit 510 can be read using an Elzerman readout. When the spin qubit is in a spin-up state, the electron that forms the spin qubit 510 can couple to a quantum dot of the single-electron transistor 518, changing the effective resistance of the single-electron transistor 518.

The outcome of the measurement is provided to the qubit state estimator 520, which determines the state of the qubit 510. In general, the outcome of the measurement of the qubit 510 will be probabilistic. For example, in one embodiment, after a CZ_{π} gate between the qubits 510, 512 and a Y_{π/2} pulse on the qubit 510, the qubit 510 will be measured to be a "0" with probability *P =* 0.5(sin(δθ)+1) and will be measured to be a "1" with probability P *=* 0.5(1-sin(δθ)), where δθ is an error in the control pulse. In an illustrative embodiment, changing the value of the parameter to the filter 504 in one direction will increase the probability of detecting a "0" (i.e., increasing δθ), and changing the value of the parameter to the filter 504 in the other direction will decrease the probability of detecting a "1" (i.e., decrease δθ). If the measurement outcome is "0," the parameter to the filter 504 is changed in one direction by a pre-determined amount, and if the measurement outcome is "1," the parameter to the filter 504 is changed in the other direction by a pre-determined amount. As a result, the parameter to the filter 504 converges toward a value that makes the probability of a "0" equal to that of a "1," which is the desired calibration value for the parameter.

The amount the parameter to the filter 504 changes on each calibration cycle is configurable. A higher step size will tend to converge faster, but a smaller step size will tend to have less noisy drift over time. In some embodiments, a higher step size may be used initially in order to quickly converge, and then a smaller step size may be used in order to reduce drift over time.

The calibration circuitry 500 may be implemented as any suitable calibration circuitry and may be located in any suitable part of the quantum compute device 200. In some embodiments, some or all of the calibration circuitry 500, such as the pulse generator 502, the filter 504, and the qubit state estimator 520 may be located in a cryogenic part of the quantum compute device 200, such as the first stage 316 or the second stage 318 of the cryogenic refrigerator 300. Some or all of the calibration circuitry 500, such as the pulse generator 502, the filter 504, and the qubit state estimator 520, may be embodied in a cryogenic integrated circuit, such as a CMOS integrated circuit. In some embodiments, the control circuitry 500 may include analog circuitry, such as an analog integrator. The analog integrator may store the filter parameter based on the amount of charge in a capacitor. To increase the filter value, the charge on the capacitor can increase, and to reduce the filter value, the charge on the capacitor can decrease. In some embodiments, the control circuitry 500 may implement the control algorithm using digital circuitry that integrates the detected readout state over time numerically.

It should be appreciated that, in an illustrative embodiment, a single pulse generator 502 may be able to be multiplexed to several different qubits. The pulse generator 502 may be multiplexed to any suitable number of qubits, such as 2-10,000. The quantum compute device 200 may include any suitable number of pulse generators 502, such as 1-1,000 or more. In some embodiments, the filter 504 is multiplexed as well as the pulse generator 502. In other embodiments, a filter 504 may be included for each qubit 510.

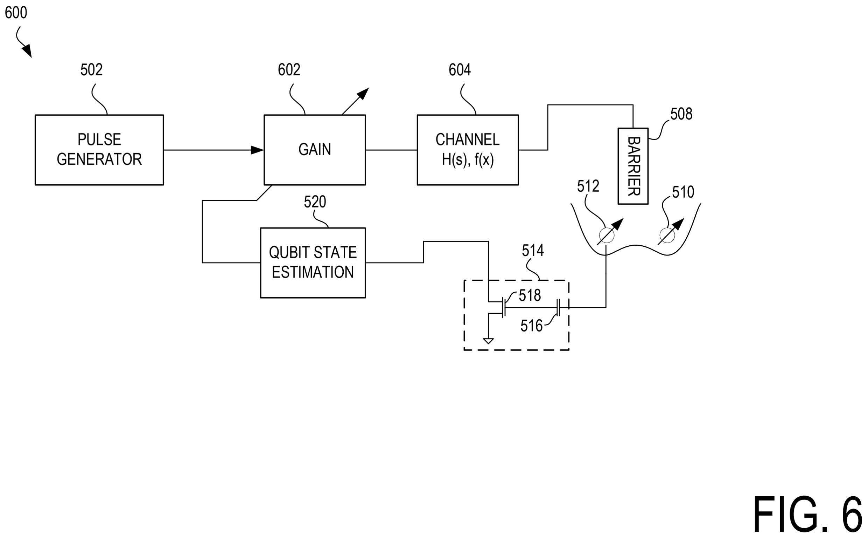

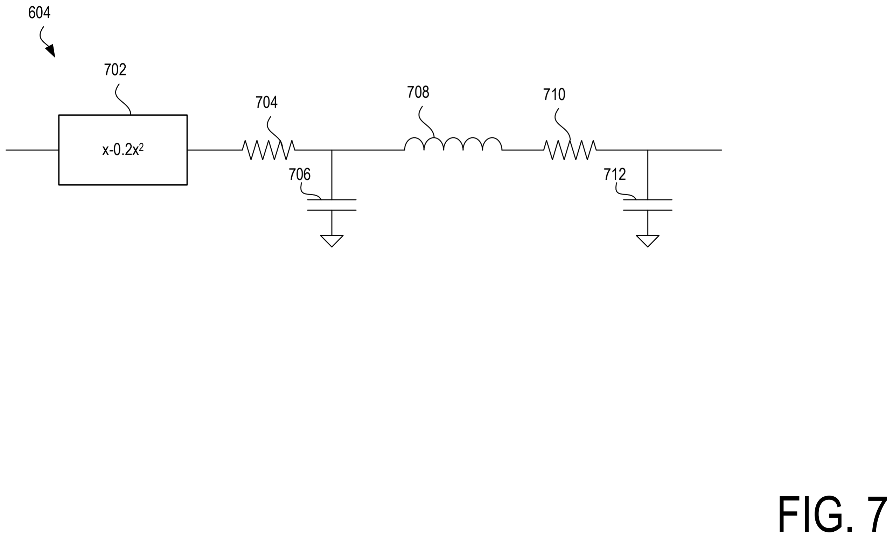

Referring now to FIG. 6, in one embodiment, calibration circuitry 600 may include the filter 504 embodied as a variable gain block 602, and the channel 604 may be characterized by a linear transmission function H(s) and a non-linear amplitude transmission function f(x). One embodiment of such a channel 604 is shown in FIG. 7. The non-linear transmission block 702 may implement the transmission function f(x) *=* x-0.2x². The linear transmission function H(s) may correspond to the circuit elements shown in FIG. 7, with a resistor 704 have a resistance of 50 Ω, a capacitor 706 having a capacitance of 10 pF, an inductor 708 having an inductance of 1.75 nH, a resistor 710 having a resistance of 1 Ω, and a capacitor 712 having a capacitance of 200 fF. The channel 604 may represent a typical channel of one or more traces in a PCB, a transmission line, solder bumps, etc., that may be between the pulse generator 502 and the barrier gate 508.

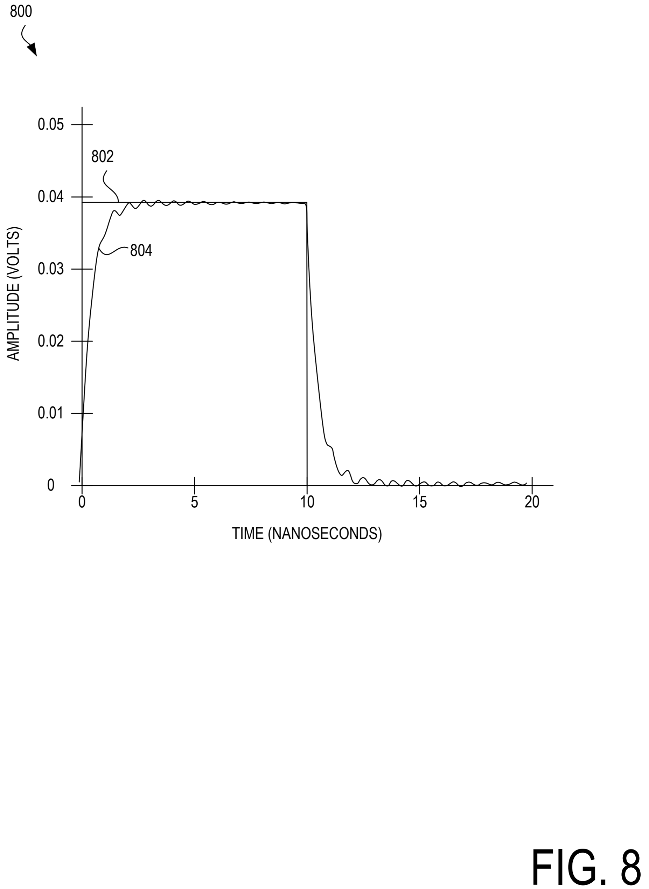

Referring now to FIG. 8, in one embodiment, a plot 800 shows the amplitude in volts of a square wave pulse 802 from a pulse generator 502, and the amplitude in volts of the pulse 804 after the channel 604. As shown in the figure, the pulse 804 is distorted as a result of passing through the channel 604.

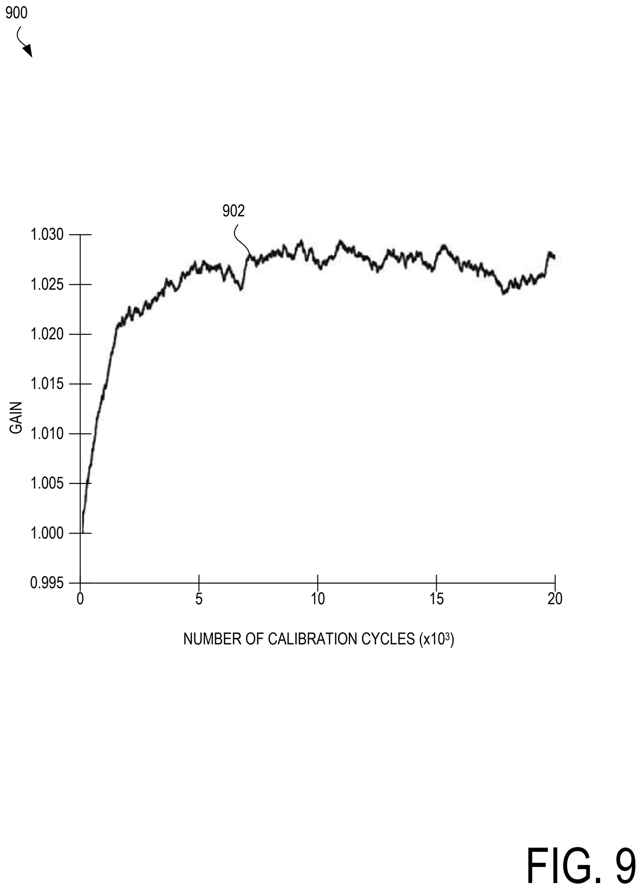

Referring now to FIG. 9, in one embodiment, a plot 900 shows the gain parameter 902 for the variable gain block 602 as a function of simulated calibration cycles. In an illustrative embodiment, the gain parameter for cycle *n* is *Gₙ*, and *Gₙ* is determined according to the formula *Gn = KQ+Gₙ₋₁,* where *K* is a parameter of the control loop set to 0.0001 in this example, *Q* is the measurement outcome of the qubit 510 (set to -0.5 if the qubit 510 is measured to be "0," and set to 0.5 if the qubit 510 is measured to be "1"), and *G*₀ is initialized to 1. As can be shown from the plot, the gain parameter converges to a value of about 1.028.

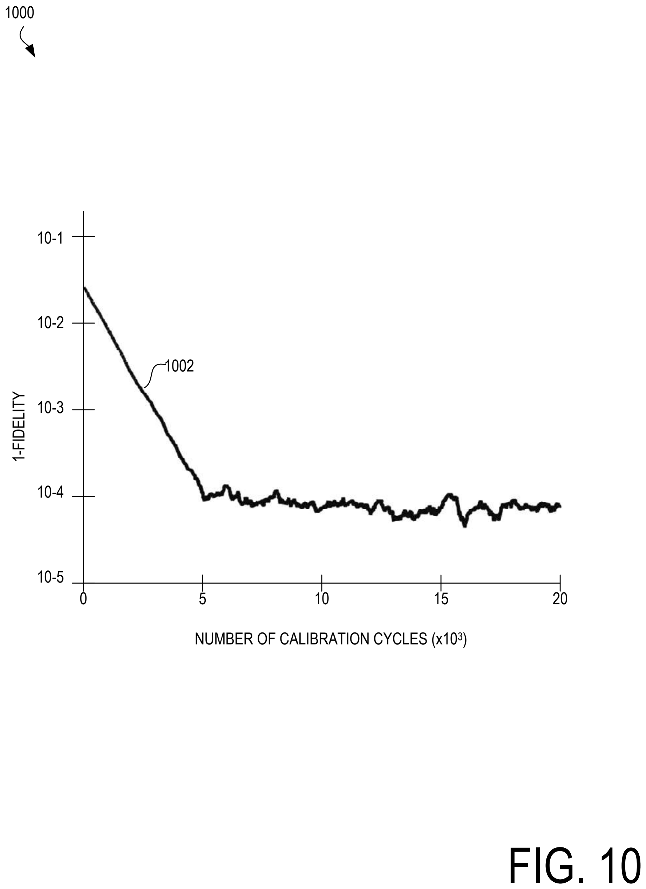

Referring now to FIG. 10, in one embodiment, a plot 1000 shows the average error 1002 in state fidelity after a pulse from the pulse generator 502 as a function of the number of calibration cycles. The average error 1002 is the error averaged over 50 iterations of the calibration routine. As can be seen from the figure, the average error quickly reaches and maintains a low value of about 10⁻⁴.

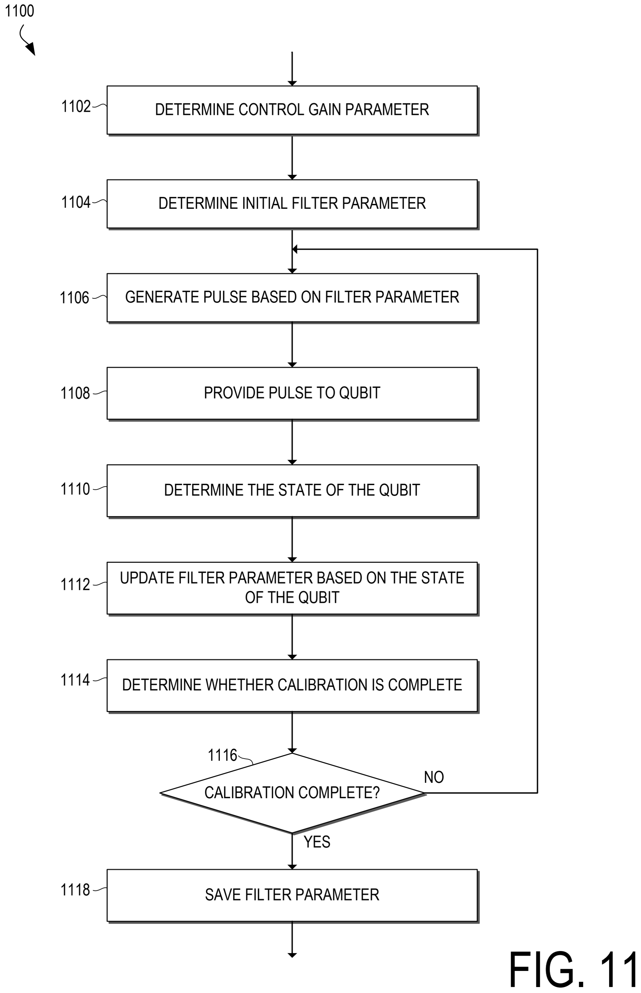

Referring now to FIG. 11, in one embodiment, a flowchart for a method 1100 for calibrating pulses to be sent to qubits of the quantum processor 210 is shown. The method 1100 may be performed by components of the quantum compute device 200, such as the processor 202, the memory 204, the quantum/classical interface circuitry 208, the control circuitry 302, etc. In an illustrative embodiment, the quantum compute device 200 executes the method 1100 before performing operations on the quantum processor 210. The quantum compute device 200 may execute the method 1100 whenever calibration may be needed, such as every time the quantum compute device 200 is booted up, any time the quantum processor 210 is cooled down to operating temperatures, after a certain period of time as passed since the last calibration, after noise measurements increase past a threshold, etc.

The method 1100 begins in block 1102, in which the quantum compute device 200 determines a control gain parameter *K.* The control gain parameter may depend on various factors, such as the parameter being tuned (e.g., amplitude, duration, frequency, parameter for an FIR, parameter for an IIR, etc.), the current error for gate operations corresponding to a pulse with the current pulse parameter, an amount of time since calibration, the parameter used on a previous calibration, etc. In an illustrative embodiment, a larger gain parameter *K* will tend to converge more quickly but with more error, and a smaller gain parameter *K* will tend to converge more slowly but with less error. In some embodiments, a larger gain parameter *K* may be chosen during an initial calibration to converge quickly, and then a smaller gain parameter *K* may be used to converge with less error.

In block 1104, an initial filter parameter is determined. In some embodiments, the initial filter parameter may be determined based on factors such as the parameter being tuned (e.g., amplitude, duration, frequency, parameter for an FIR, parameter for an IIR, etc.). After an initial calibration cycle, the filter parameter may be stored in a register or other memory or storage location associated with the qubit 510 being calibrated. The filter parameter that was previously determined may be accessed in block 1104 to determine the initial filter parameter.

In block 1106, a pulse is generated from the pulse generator 502 based on the filter parameter. The filter parameter may be provided to the pulse generator 502, or the filter parameter may be provided to a separate filter 504, such as a variable gain amplifier, a FIR filter, an IIR filter, etc.

In block 1108, the pulse is provided to the qubit. In an illustrative embodiment, the pulse is a voltage provided to a barrier gate 508, and the pulse causes an exchange interaction between the qubits 510, 512. In other embodiments, the pulse may be, e.g., an RF pulse provided to a qubit 510 to change the spin state of the qubit 510. In block 1110, the state of the qubit 510 is determined. The state of the qubit 510 may be determined using any suitable approach, such as by coupling the qubit 510 to a single-electron transistor 518.

In block 1112, the filter parameter is updated based on the state of the qubit, the previous value of the filter parameter, and the control gain parameter. In an illustrative embodiment, the filter parameter is updated using the formula *Gₙ = KQ+Gₙ₋₁,* where *K* is the control gain parameter, *Q* represents the measurement of the state of the qubit (e.g., *Q* = -0.5 if the qubit is a "0," and *Q =* 0.5 if the qubit is a "1"), and *G*_{*n*-1} is the previous value of the filter parameter.

In block 1114, the quantum compute device 200 determines whether calibration is complete. In an illustrative embodiment, the calibration loops continuously until a condition is met, such as an average error value (e.g., the difference in fidelity from unity) due to the pulse with the filter parameter is below a threshold, the calibration has operated for a certain number of cycles, the calibration has operated for a certain amount of time, when another operation on the quantum compute device 200 is complete, etc.

In block 1116, if calibration is not complete, the method 1100 loops back to block 1106 to generate another pulse based on the filter parameter. In some embodiments, the state of the qubit 510 may be set or reset before generating a new pulse.

If calibration is complete, the method 1100 proceeds to block 1118, in which the quantum compute device 200 saves the filter parameter. The filter parameter may be saved in a register, memory location, or other storage location associated with the qubit 510. The filter parameter may then be used to generate pulses to manipulate the qubit 510 during operation of the quantum compute device 200.

In an illustrative embodiment, only one parameter is calibrated to control a pulse on the qubit 510. In other embodiments, several parameters may be calibrated serially or in parallel. For example, in one embodiment, a pulse duration may be calibrated first, and then a pulse amplitude may be calibrated. In some embodiments, multiple calibrations may occur simultaneously. For example, calibration of control pulses provided to nearby qubits may be performed at the same time, allowing for factors such as cross-talk to be corrected as well.

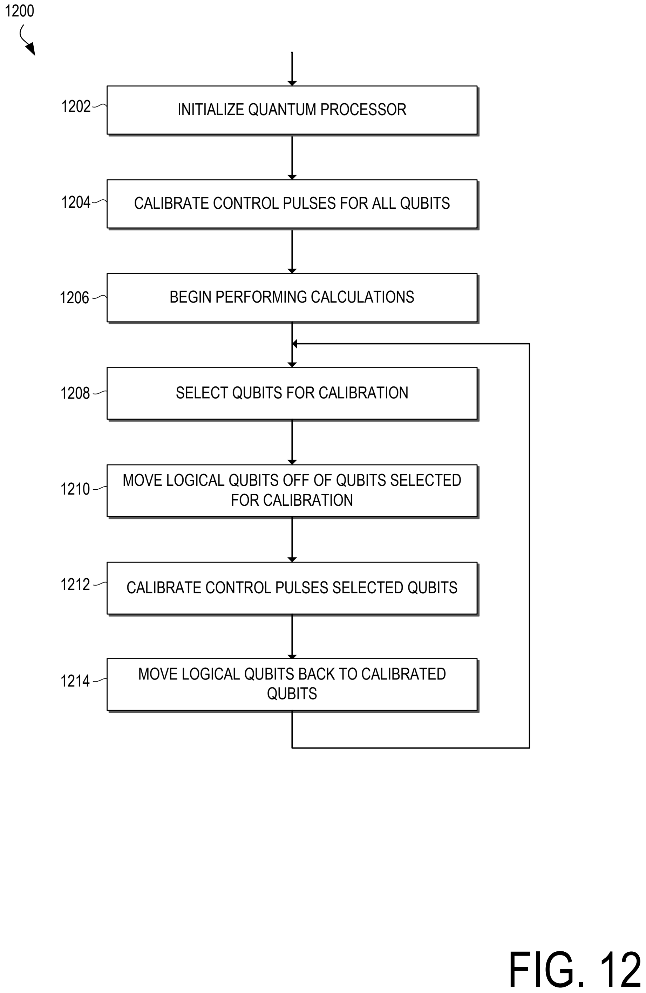

Referring now to FIG. 12, in one embodiment, a flowchart for a method 1200 for operating a quantum processor 210 is shown. The method 1200 may be performed by components of the quantum compute device 200, such as the processor 202, the memory 204, the quantum/classical interface circuitry 208, the control circuitry 302, etc.

The method 1200 begins in block 1202, in which the quantum compute device 200 initializes the quantum processor 210, such as by cooling the quantum processor 210 to an operating temperature, initializing voltages, etc.

In block 1204, the quantum compute device 200 calibrates control pulses for all qubits. The quantum compute device 200 may perform the method 1100 described above in order to calibrate control pulses for each qubit. It should be appreciated that the control pulses for multiple qubits can be calibrated simultaneously. In bock 1206, the quantum compute device 200 begins performing calculations on the quantum processor 210.

In block 1208, the quantum compute device 200 selects one or more qubits for calibrations. The qubits may be selected in any suitable manner, such as based on an amount of noise measured, an amount of time since the selected qubits were last calibrated, a previous calculation performed by the quantum compute device 200, a future calculation to be performed by the quantum compute device 200, a sensor value such as a temperature value, a voltage noise value, etc. In block 1210, logical qubits involved in calculations on the quantum processor 210 are moved off of the qubits selected for calibration.

In block 1212, control pulses for the selected qubits are calibrated, such as by performing the method 1100 for each of the selected qubits. After calibration is complete, the logical qubits may be moved back to the calibrated qubits in block 1214.

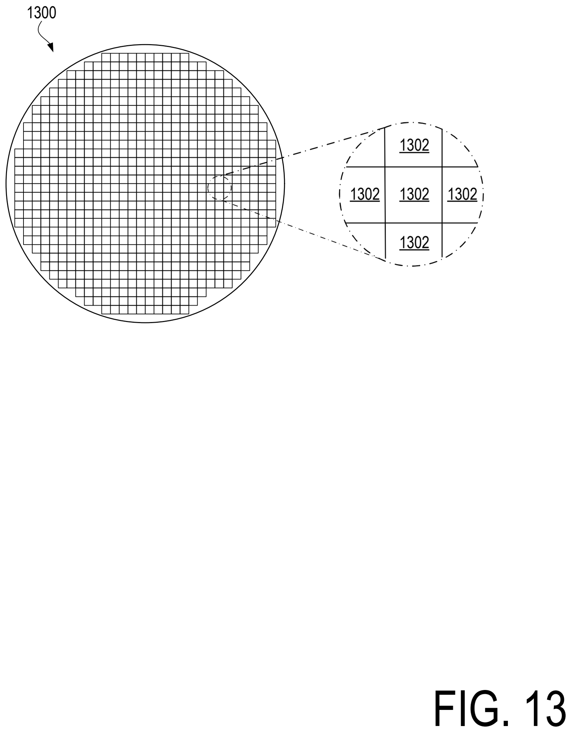

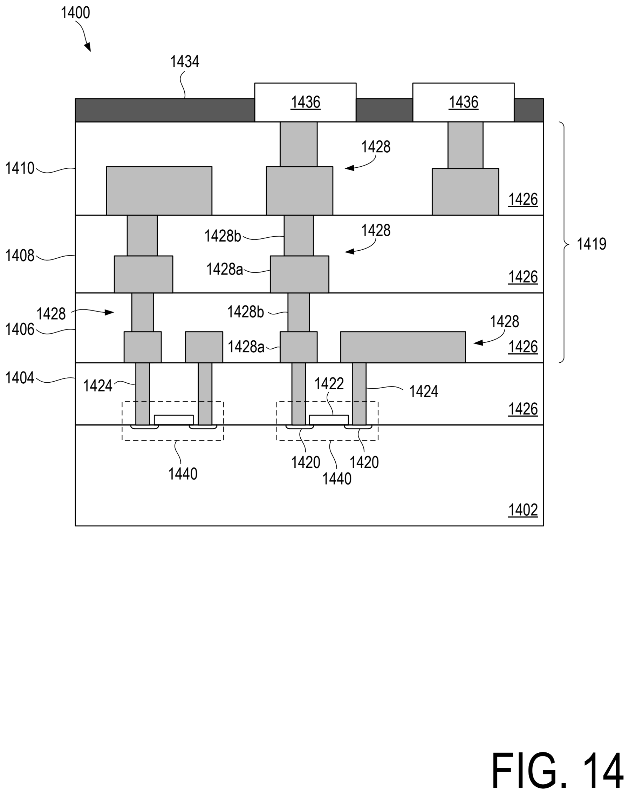

FIG. 13 is a top view of a wafer 1300 and dies 1302 that may be included in any of the microelectronic assemblies disclosed herein (e.g., as any suitable ones of the dies for the quantum processor 210). The wafer 1300 may be composed of semiconductor material and dies 1302 having integrated circuit structures formed on a surface of the wafer 1300. The individual dies 1302 may be a repeating unit of an integrated circuit product that includes any suitable integrated circuit. After the fabrication of the semiconductor product is complete, the wafer 1300 may undergo a singulation process in which the dies 1302 are separated from one another to provide discrete "chips" of the integrated circuit product. The dies 1302 may be any of the dies for the quantum processor 210 disclosed herein. The dies 1302 may include one or more transistors (e.g., transistors 1440 of FIG. 14, discussed below), supporting circuitry to route electrical signals to the transistors, passive components (e.g., signal traces, resistors, capacitors, or inductors), and/or any other integrated circuit components that can be fabricated on the wafer. In some embodiments, the wafer 1300 or the dies 1302 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), logic gates (e.g., AND, OR, NAND, and NOR gates), or any other suitable circuit element. Multiple ones of these devices and components may be combined on a single die. For example, a memory array formed by multiple memory devices may be formed on the same die as a processor unit or other logic configured to store information in the memory devices or execute instructions stored in the memory array. Various ones of the microelectronic assemblies disclosed herein may be manufactured using a die-to-wafer assembly technique in which some dies are attached to a wafer 1300 that include others of the dies, and the wafer 1300 is subsequently singulated.

FIG. 14 is a cross-sectional view of an integrated circuit structure 1400 that may be included in any of the microelectronic assemblies disclosed herein (e.g., in any of the dies for the quantum processor 210). Multiple instances of the integrated circuit structure 1400 may be included in the dies 1302 (FIG. 13). The integrated circuit structure 1400 may be formed on a die substrate 1402. The die substrate 1402 may be a semiconductor substrate composed of semiconductor material including, for example, n-type or p-type materials (or a combination of both). The die substrate 1402 may include, for example, a crystalline substrate formed using a bulk silicon or a siliconon-insulator (SOI) substructure. In some embodiments, the die substrate 1402 can comprise a layer of silicon on top of an SOI layer with bulk silicon below the SOI layer. In some embodiments, the die substrate 1402 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1402. Although a few examples of materials from which the die substrate 1402 may be formed are described here, any material that may serve as a foundation for an integrated circuit structure 1400 may be used. The die substrate 1402 may be part of a singulated die (e.g., dies 1302 of FIG. 13) or a wafer (e.g., wafer 1300 of FIG. 13).

The integrated circuit structure 1400 may include device layer 1404 disposed on the die substrate 1402. The device layer 1404 may include features of transistors 1440 (e.g., metal oxide semiconductor field-effect transistors (MOSFETs)) formed on the die substrate 1402. The transistors 1440 may include, for example, source and drain regions (S/D regions 1420), a gate 1422 to control current flow between the S/D regions 1420, and S/D contacts 1424 to route electrical signals to and from the S/D regions 1420. The transistors 1440 may include additional features not depicted for the sake of clarity, such as device isolation regions, gate contacts, and the like. The transistors 1440 are not limited to the type and configuration depicted in FIG. 14 and may include a wide variety of other types and configurations such as, for example, non-planar transistors, or a combination of planar and non-planar transistors. Non-planar transistors may include FinFET transistors, such as double-gate transistors or tri-gate transistors, and wrap-around or all-around gate transistors, such as nanoribbon, nanosheet, or nanowire transistors.

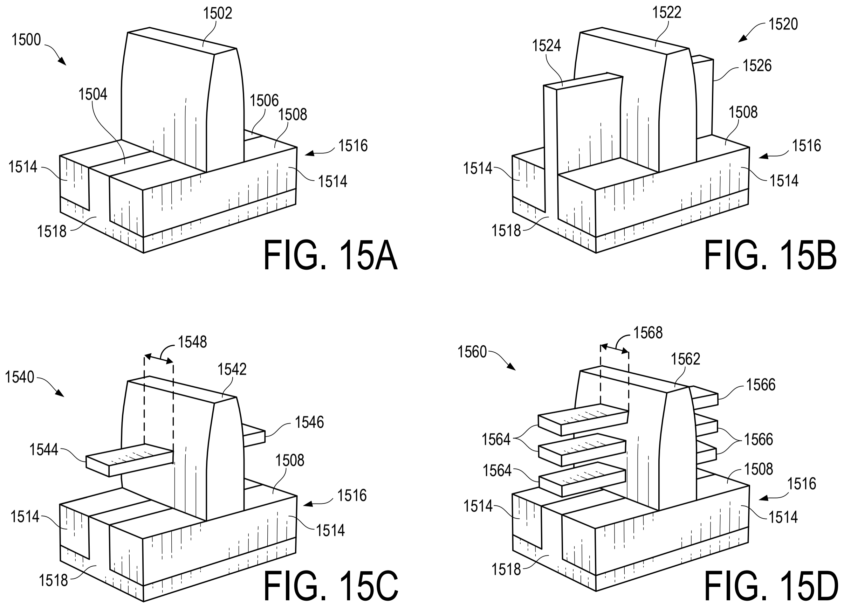

FIGS. 15A-15D are perspective views of example planar, FinFET, gate-all-around, and stacked gate-all-around transistors. The transistors illustrated in FIGS. 15A-15D are formed on a substrate 1516 having a substrate surface 1508 and a bulk region 1518. Isolation regions 1514 separate the source and drain regions of the transistors from other transistors.

FIG. 15A is a perspective view of an example transistor 1500 comprising a gate 1502 that controls current flow between a source region 1504 and a drain region 1506. The transistor 1500 is planar in that the source region 1504, the drain region 1506 and the substrate surface 1508 lie in the same plane.

FIG. 15B is a perspective view of an example transistor 1520 comprising a gate 1522 that controls current flow between a source region 1524 and a drain region 1526. The transistor 1520 is non-planar in that the source region 1524 and the drain region 1526 comprise "fins" that extend upwards from the substrate surface 1508. The transistor 1520 can be referred to as a FinFET. As the gate 1522 encompasses three sides of the fin that extends from the source region 1524 to the drain region 1526, the transistor 1520 can be considered a tri-gate transistor. FIG. 15B illustrates one S/D fin extending through the gate 1522, but multiple S/D fins can extend through the gate of a FinFET transistor.

FIG. 15C is a perspective view of a transistor 1540 comprising a gate 1542 that controls current flow between a source region 1544 and a drain region 1546. The transistor 1540 is non-planar in that the source region 1544 and the drain region 1546 lie in a different plane than the substrate surface 1508. As the gate 1542 encompasses all sides of the channel region of the transistor 1540 that extends from the source region 1544 to the drain region 1546, the transistor 1540 can be referred to as a gate-all-around (GAA) transistor.

FIG. 15D is a perspective view of a transistor 1560 comprising a gate 1562 that controls current flow between multiple elevated source regions 1564 and multiple elevated drain regions 1566. The transistor 1560 is a stacked GAA transistor as the gate controls the flow of current between multiple elevated S/D regions stacked on top of each other. The transistors 1540 and 1560 are considered gate-all-around transistors as the gates encompass all sides of the channel regions of the transistor that extends from the source regions to the drain regions. The transistors 1540 and 1560 can alternatively be referred to as nanowire, nanosheet, or nanoribbon transistors depending on the width (e.g., widths 1548 and 1568 of transistors 1540 and 1560, respectively) of the channel regions extending through the gate.

Returning to FIG. 14, transistors 1440 may include a gate 1422 formed of at least two layers, a gate dielectric, and a gate electrode. The gate dielectric may include one or more layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For PMOS transistors, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For NMOS transistors, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, such as in the FinFET illustrated in FIG. 15B, the gate electrode may have an upside-down U-shape that includes a top portion substantially parallel to the surface of the die substrate 1402 and two side portions that are substantially perpendicular to the top surface of the die substrate 1402. In other embodiments, such as the planar FET illustrated in FIG. 15A, at least one of the metal layers that form the gate electrode may be a planar layer that is substantially parallel to the top surface of the die substrate 1402 without side portions. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack (comprising the gate dielectric and the gate electrode) to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of sidewall spacer pairs may be used; for instance, two pairs, three pairs, or four pairs of sidewall spacers may be formed on opposing sides of the gate stack.

The S/D regions 1420 may be formed within the die substrate 1402 adjacent to the gate 1422 of transistors 1440. The S/D regions 1420 may be formed using an implantation/diffusion process or an etching/deposition process, for example. In the former process, dopants such as boron, aluminum, antimony, phosphorous, or arsenic may be ion-implanted into the die substrate 1402 to form the S/D regions 1420. An annealing process that activates the dopants and causes them to diffuse further into the die substrate 1402 may follow the ion implantation process. In the latter process, the die substrate 1402 may first be etched to form recesses at the locations of the S/D regions 1420. An epitaxial deposition process may then be carried out to fill the recesses with material that is used to fabricate the S/D regions 1420. In some implementations, the S/D regions 1420 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1420 may be formed using one or more alternate semiconductor materials such as germanium or a group III-V material or alloy. In further embodiments, one or more layers of metal and/or metal alloys may be used to form the S/D regions 1420.

Electrical signals, such as power and/or information-carrying signals (e.g., input/output (I/O) signals, may be routed to and/or from devices (e.g., transistors 1440) of the device layer 1404 through one or more interconnect layers disposed on the device layer 1404 (illustrated in FIG. 14 as interconnect layers 1406-1410). For example, electrically conductive features of the device layer 1404 (e.g., the gate 1422 and the S/D contacts 1424) may be electrically coupled with interconnect structures 1428 of the interconnect layers 1406-1410. The one or more interconnect layers 1406-1410 may form a metallization stack 1419 (which can also be referred to as an "ILD stack" (inter-layer dielectric stack)) of the integrated circuit structure 1400.

The interconnect structures 1428 may be arranged within the interconnect layers 1406-1410 to route electrical signals according to a wide variety of designs; in particular, the arrangement is not limited to the particular configuration of interconnect structures 1428 depicted in FIG. 14. Although a particular number of interconnect layers 1406-1410 is depicted in FIG. 14, embodiments of the present disclosure include integrated circuit structures having more or fewer interconnect layers than depicted.

In some embodiments, the interconnect structures 1428 may include traces or lines 1428a and/or vias 1428b filled with an electrically conductive material such as a metal. The lines 1428a may be arranged to route electrical signals in a direction of a plane that is substantially parallel with a surface of the die substrate 1402 upon which the device layer 1404 is formed. For example, the lines 1428a may route electrical signals in a direction in and out of the page and/or in a direction across the page from the perspective of FIG. 14. The vias 1428b may be arranged to route electrical signals in a direction of a plane that is substantially perpendicular to the surface of the die substrate 1402 upon which the device layer 1404 is formed. In some embodiments, lines 1428a of different interconnect layers 1406-1410 are electrically coupled by vias 1428b.

The interconnect layers 1406-1410 may include a dielectric material 1426 within which the interconnect structures 1428 are disposed, as shown in FIG. 14. In some embodiments, dielectric material 1426 in different ones of the interconnect layers 1406-1410 may have different compositions; in other embodiments, the composition of the dielectric material 1426 between different interconnect layers 1406-1410 may be the same. The device layer 1404 may include a dielectric material 1426 within which the transistors 1440 are disposed and upon which a bottom layer of the metallization stack is located. The dielectric material 1426 that is part of the device layer 1404 may have a different composition than the dielectric material 1426 included in the interconnect layers 1406-1410; in other embodiments, the composition of the dielectric material 1426 in the device layer 1404 may be the same as a dielectric material 1426 included in any one of the interconnect layers 1406-1410.

A first interconnect layer 1406 (which can be referred to as a Metal 1 or "M1" layer) may be formed directly on the device layer 1404. In some embodiments, the first interconnect layer 1406 may include lines 1428a and/or vias 1428b, as shown. The lines 1428a of the first interconnect layer 1406 may be coupled with contacts (e.g., the S/D contacts 1424) of the device layer 1404. The vias 1428b of the first interconnect layer 1406 may be coupled with the lines 1428a of a second interconnect layer 1408.

The second interconnect layer 1408 (which can be referred to as a Metal 2 or "M2" layer) may be formed directly on the first interconnect layer 1406. In some embodiments, the second interconnect layer 1408 may include vias 1428b to couple the lines 1428a of the second interconnect layer 1408 with the lines 1428a of a third interconnect layer 1410. Although the lines 1428a and the vias 1428b are structurally delineated with a line within individual interconnect layers for the sake of clarity, the lines 1428a and the vias 1428b may be structurally and/or materially contiguous (e.g., simultaneously filled during a dual-damascene process) in some embodiments.

The third interconnect layer 1410 (which can be referred to as a Metal 3 or "M3" layer) (and additional interconnect layers, as desired) may be formed in succession on the second interconnect layer 1408 according to similar techniques and configurations described in connection with the second interconnect layer 1408 or the first interconnect layer 1406. In some embodiments, the interconnect layers that are "higher up" in the metallization stack 1419 in the integrated circuit structure 1400 (i.e., farther away from the device layer 1404) may be thicker than the interconnect layers that are lower in the metallization stack 1419, with lines 1428a and vias 1428b in the higher interconnect layers being thicker than those in the lower interconnect layers.

The integrated circuit structure 1400 may include a solder resist material 1434 (e.g., polyimide or similar material) and conductive contacts 1436 formed on the stack of interconnect layers 1406-1410. In FIG. 14, the conductive contacts 1436 are illustrated as taking the form of bond pads. The conductive contacts 1436 may be electrically coupled with interconnect structures 1428 of the top-most layer in the metallization stack 1419 and configured to route electrical signals between the transistors 1440 and components external to the integrated circuit structure 1400. For example, solder bonds may be formed on the conductive contacts 1436 to mechanically and/or electrically couple an integrated circuit component comprising the integrated circuit structure 1400 with another component (e.g., a printed circuit board). The integrated circuit structure 1400 may include additional or alternate structures to route electrical signals from the interconnect layers 1406-1410; for example, the conductive contacts 1436 may include other analogous features (e.g., posts) that can route the electrical signals between the transistors 1440 and external components.

In some embodiments in which the integrated circuit structure 1400 is part of a double-sided die, the integrated circuit structure 1400 may include a second metallization stack (not shown) located on the opposite side of the die substrate 1402 from the device layer 1404. This second metallization stack may include multiple interconnect layers as discussed above with reference to the interconnect layers 1406-1410. Through-silicon vias (TSVs) that extend through the die substrate 1402 can provide electrically conductive pathways from the transistors 1440 to the second metallization stack and the second metallizaton stack can electrically couple the TSVs to additional conductive contacts (not shown) located on the opposite side of the integrated circuit structure 1400 from the conductive contacts 1436.

In some embodiments, TSVs extending through the die substrate 1402 can be used for routing power and ground signals from conductive contacts located on the opposite side of the integrated circuit structure 1400 from the conductive contacts 1436 to the transistors 1440 and any other components integrated into the integrated circuit structure 1400, and the metallization stack 1419 can be used to route information-carrying signals from the conductive contacts 1436 to transistors 1440 and any other components integrated into the integrated circuit structure 1400. Put another way, the routing of power and ground signals to the transistors 1440 can be separated (via a back-side or bottom-side metallizaton stack and TSVs) from the routing of information-carrying signals to the transistors. The power and ground signals are provided by a back-side or bottom-side metallization stack and TSVs, and information-carrying signals are provide by a top-side metallization stack (e.g.,metallization stack 1419).

Several integrated circuit dies may be stacked with one or more TSVs in the individual stacked dies providing connection between one of the dies to any of the other dies in the stack. For example, one or more high-bandwidth memory (HBM) integrated circuit dies can be stacked on top of a base integrated circuit die and TSVs in the HBM dies can provide connection between the individual HBM dies and the base integrated circuit die. Conductive contacts can provide additional connections between adjacent integrated circuit dies in the stack. In some embodiments, the conductive contacts can be fine-pitch solder bumps (microbumps).

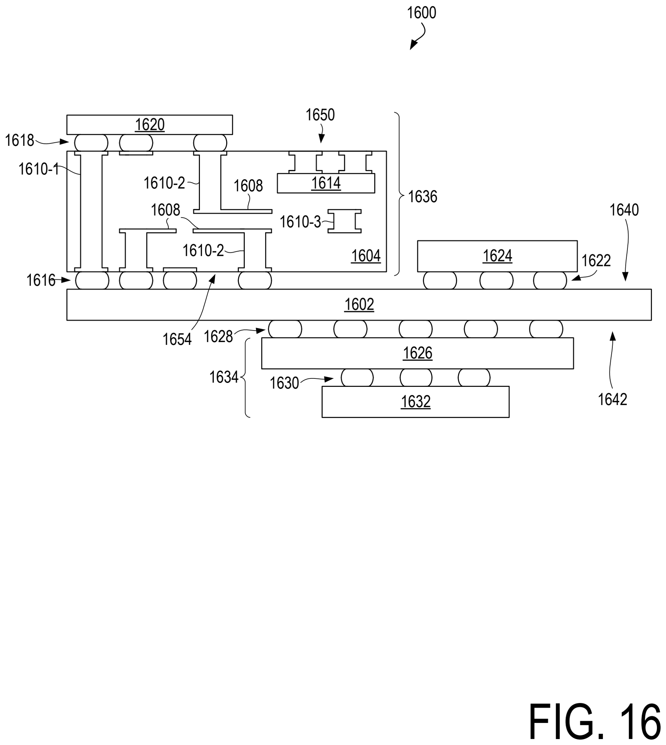

FIG. 16 is a cross-sectional view of an integrated circuit device assembly 1600 that may include any of the microelectronic assemblies disclosed herein. In some embodiments, the integrated circuit device assembly 1600 may be a microelectronic assembly. The integrated circuit device assembly 1600 includes a number of components disposed on a circuit board 1602 (which may be a motherboard, system board, mainboard, etc.). The integrated circuit device assembly 1600 includes components disposed on a first face 1640 of the circuit board 1602 and a second face 1642 of the circuit board 1602, the second face 1642 opposing the first face 1640. Generally, components may be disposed on either or both of the first face 1640 and the second face 1642 of the circuit board 1602. Any of the integrated circuit components discussed below with reference to the integrated circuit device assembly 1600 may take the form of any suitable ones of the embodiments of the microelectronic assemblies disclosed herein.

In some embodiments, the circuit board 1602 may be a printed circuit board (PCB) including multiple metal (or interconnect) layers separated from one another by layers of dielectric material and interconnected by electrically conductive vias. The individual metal layers comprise conductive traces. The metal layers may be formed in a desired pattern to route electrical signals between the components electrically coupled to the circuit board 1602. In other embodiments, the circuit board 1602 may be a non-PCB substrate.

The integrated circuit device assembly 1600 illustrated in FIG. 16 includes a package-on-interposer structure 1636 coupled to the first face 1640 of the circuit board 1602 by coupling components 1616. The coupling components 1616 may electrically and mechanically couple the package-on-interposer structure 1636 to the circuit board 1602 and may include solder balls (as shown in FIG. 16), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. (Thus, a coupling component may comprise a conductive contact.) The coupling components 1616 may serve as the coupling components illustrated or described for any substrate assembly or substrate assembly components described herein (e.g., integrated circuit components), as appropriate.

The package-on-interposer structure 1636 may include an integrated circuit component 1620 coupled to an interposer 1604. The interposer 1604 may provide an intervening substrate used to bridge the circuit board 1602 and the integrated circuit component 1620. The integrated circuit component 1620 is coupled to the interposer 1604 by coupling components 1618. The coupling components 1618 may take any suitable form, such as the forms discussed above with reference to the coupling components 1616. Although FIG. 16 shows just one integrated circuit component attached to the interposer, multiple integrated circuit components may be coupled to the interposer 1604. Additional interposers may be coupled to the interposer 1604.

The integrated circuit component 1620 may be a packaged or unpacked integrated circuit product that includes one or more integrated circuit dies (e.g., the die 1302 of FIG. 13, a die comprising the integrated circuit structure 1400 of FIG. 14) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one unpackaged example of an integrated circuit component 1620, a single monolithic integrated circuit die comprises solder bumps attached to contacts on the die. The solder bumps allow the die to be directly attached to the interposer 1604. The integrated circuit component 1620 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1620 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1620 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1620 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1604 may spread connections to a wider or narrower pitch or reroute a connection to a different connection. For example, the interposer 1604 may couple coupling components 1618 having a first pitch to coupling components 1616 having a wider pitch than the first pitch. In the embodiment illustrated in FIG. 16, the integrated circuit component 1620 and the circuit board 1602 are attached to opposing sides of the interposer 1604. In other embodiments, the integrated circuit component 1620 and the circuit board 1602 may be attached to a same side of the interposer 1604. In some embodiments, three or more components may be interconnected by way of the interposer 1604.

In some embodiments, the interposer 1604 may be formed as a PCB, including multiple metal layers separated from one another by layers of dielectric material and interconnected by electrically conductive vias. In some embodiments, the interposer 1604 may be formed of an epoxy resin, a fiberglass-reinforced epoxy resin, an epoxy resin with inorganic fillers, a ceramic material, or a polymer material such as polyimide. In some embodiments, the interposer 1604 may be formed of alternate rigid or flexible materials that may include the same materials described above for use in a semiconductor substrate, such as silicon, germanium, and other group III-V and group IV materials. The interposer 1604 may include metal interconnects 1608 and vias, including but not limited to through hole vias 1610-1 (that extend from a first face 1650 of the interposer 1604 to a second face 1654 of the interposer 1604), blind vias 1610-2 (that extend from the first face 1650 or the second face 1654 of the interposer 1604 to an internal metal layer), and buried vias 1610-3 (that connect internal metal layers).

In some embodiments, the interposer 1604 can comprise a silicon interposer. Through silicon vias (TSV) extending through the silicon interposer can connect connections on a first face of a silicon interposer to an opposing second face of the silicon interposer. In some embodiments, an interposer 1604 comprising a silicon interposer can further comprise one or more routing layers to route connections on a first face of the interposer 1604 to an opposing second face of the interposer 1604.

In some embodiments the interposer 1604, as well as the circuit board 1602, can comprise an amorphous solid layer of glass (which can be referred to a glass core or glass substrate). In some embodiments, the layer of glass can comprise silica (comprising silicon dioxide (SiO₂)), fused silica, aluminosilicate (comprising aluminum oxide (Al₂O₃) and silicon dioxide), borosilicate (comprising silicon dioxide and boron trioxide (B₂O₃)), or alumino-borosilicate (comprising aluminum oxide, silicon dioxide, and boron trioxide). In some embodiments, the layer of glass can comprise one or more of the following additives: aluminum oxide, boron trioxide, magnesium oxide (MgO), calcium oxide (CaO), strontium oxide (SrO), barium oxide (BaO), tin(IV) oxide (SnO₂), nitrous oxide (Na₂O), potassium oxide (K₂O), diphosphorous trioxide (P₂O₃), zirconium dioxide (ZrO₂), lithium oxide (Li₂O), titanium, and zinc. In some embodiments, the layer of glass can comprise silicon and oxygen, as well as one or more of aluminum, boron, magnesium, calcium, barium, tin, sodium, potassium, strontium, phosphorous, zirconium, lithium, titanium, and zinc. In some embodiments, the layer of glass comprises at least 23 percent silicon by weight, at least 26 percent oxygen by weight, and at least five percent aluminum by weight. In some embodiments, the layer of glass does not include an organic adhesive or an organic material. For example, the layer of glass is not a substrate or a board comprising glass fibers and an epoxy binder, such as a printed circuit board (PCB) comprising multiple metal (or interconnect) layers separated from one another by layers of dielectric material (e.g., FR-4 or other fiberglass-reinforced epoxy laminate) and interconnected by electrically conductive vias.

In some embodiments, the glass layer has a thickness in the range of about 50 microns to about 1.4 millimeters. In some embodiments, the glass layer is or is part of a multi-layer glass substrate (a coreless substrate). Individual glass layers in a multi-layer glass substrate can have a thickness in the range of about 25 microns to about 50 microns. In some embodiments, a glass layer can have a length in the range of about 10 millimeters to about 250 millimeters on a side (e.g., can have an area in the range of about 10 mm x 10 mm to about 250 mm x 250 mm). In some embodiments, the glass layer comprises a rectangular prism volume with sections or portions (e.g., through-glass vias) removed and filled with other metals (e.g., metal).

In some embodiments, redistribution layers (RDL) can be located on either or both sides of the glass layer to provide electrically conductive paths from top and/or bottom surfaces of the interposer 1604 or circuit board 1602 to the glass layer. The glass layer can comprise through-glass vias (TGVs) that extend through the glass layer to provide electrically conductive paths through the glass core, glass substrate, or glass layer.

The interposer 1604 may further include embedded devices 1614, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1604. The package-on-interposer structure 1636 may take the form of any of the package-on-interposer structures known in the art.

The integrated circuit device assembly 1600 may include an integrated circuit component 1624 coupled to the first face 1640 of the circuit board 1602 by coupling components 1622. The coupling components 1622 may take the form of any of the embodiments discussed above with reference to the coupling components 1616, and the integrated circuit component 1624 may take the form of any of the embodiments discussed above with reference to the integrated circuit component 1620.

The integrated circuit device assembly 1600 illustrated in FIG. 16 further includes a package-on-package structure 1634 coupled to the second face 1642 of the circuit board 1602 by coupling components 1628. The package-on-package structure 1634 may include an integrated circuit component 1626 and an integrated circuit component 1632 coupled together by coupling components 1630 such that the integrated circuit component 1626 is disposed between the circuit board 1602 and the integrated circuit component 1632. The coupling components 1628 and 1630 may take the form of any of the embodiments of the coupling components 1616 discussed above, and the integrated circuit components 1626 and 1632 may take the form of any of the embodiments of the integrated circuit component 1620 discussed above. The package-on-package structure 1634 may be configured in accordance with any of the package-on-package structures known in the art.

FIG. 17 is a block diagram of an example electrical device 1700 that may include any of the microelectronic assemblies disclosed herein. For example, any suitable ones of the components of the electrical device 1700 may include one or more of the integrated circuit device assembly 1600, integrated circuit component 1620, or integrated circuit structure 1400, integrated circuit dies 1302 disclosed herein, and may be arranged in any of the microelectronic assemblies disclosed herein. A number of components are illustrated in FIG. 17 as included in the electrical device 1700, but any one or more of these components may be omitted or duplicated, as suitable for the application. In some embodiments, some or all of the components included in the electrical device 1700 may be attached to one or more motherboards mainboards, or system boards. In some embodiments, one or more of these components are fabricated onto a single system-on-a-chip (SoC) die.

Additionally, in various embodiments, the electrical device 1700 may not include one or more of the components illustrated in FIG. 17, but the electrical device 1700 may include interface circuitry for coupling to the one or more components. For example, the electrical device 1700 may not include a display device 1706, but may include display device interface circuitry (e.g., a connector and driver circuitry) to which a display device 1706 may be coupled. In another set of examples, the electrical device 1700 may not include an audio input device 1724 or an audio output device 1708, but may include audio input or output device interface circuitry (e.g., connectors and supporting circuitry) to which an audio input device 1724 or audio output device 1708 may be coupled.

The electrical device 1700 may include one or more processor units 1702. As used herein, the terms "processor unit," "processing unit," or "processor" may refer to any device or portion of a device that processes electronic data from registers and/or memory to transform that electronic data into other electronic data that may be stored in registers and/or memory. The one or more processor units 1702 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1700 may include a memory 1704, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1704 may include memory that is located on the same integrated circuit die as the one or more processor units 1702. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments of the electrical device 1700, a first one of the one or more processor units 1702 can be heterogeneous or asymmetric to a second one of the one or more processor units 1702 in the electrical device 1700. There can be a variety of differences between the one or more processor units 1702 in a system in terms of a spectrum of metrics of merit including architectural, microarchitectural, thermal, power consumption characteristics, and the like. These differences can effectively manifest themselves as asymmetry and heterogeneity among the one or more processor units 1702 in the electrical device 1700.

In some embodiments, the electrical device 1700 may include a communication component 1712. For example, the communication component 1712 can manage wireless communications for the transfer of data to and from the electrical device 1700. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1712 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1712 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1712 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1712 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1712 may operate in accordance with other wireless protocols in other embodiments. The electrical device 1700 may include an antenna 1722 to facilitate wireless communications and/or to receive other wireless communications (such as AM or FM radio transmissions).

In some embodiments, the communication component 1712 may manage wired communications, such as electrical, optical, or any other suitable communication protocols (e.g., IEEE 802.3 Ethernet standards). In some embodiments, the electrical device 1700 comprises multiple communication components. For instance, a first communication component may be dedicated to shorter-range wireless communications such as Wi-Fi or Bluetooth, and a second communication component may be dedicated to longer-range wireless communications such as global positioning system (GPS), EDGE, GPRS, CDMA, WiMAX, LTE, EV-DO, or others. In some embodiments, a first communication component may be dedicated to wireless communications, and a second communication component may be dedicated to wired communications.

The electrical device 1700 may include battery/power circuitry 1714. The battery/power circuitry 1714 may include one or more energy storage devices (e.g., batteries or capacitors) and/or circuitry for coupling components of the electrical device 1700 to an energy source separate from the electrical device 1700 (e.g., AC line power).

The electrical device 1700 may include a display device 1706 (or corresponding interface circuitry, as discussed above). The display device 1706 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1700 may include an audio output device 1708 (or corresponding interface circuitry, as discussed above). The audio output device 1708 may include any embedded or wired or wirelessly connected external device that generates an audible indicator, such as speakers, headsets, or earbuds.

The electrical device 1700 may include an audio input device 1724 (or corresponding interface circuitry, as discussed above). The audio input device 1724 may include any embedded or wired or wirelessly connected device that generates a signal representative of a sound, such as microphones, microphone arrays, or digital instruments (e.g., instruments having a musical instrument digital interface (MIDI) output). The electrical device 1700 may include a Global Navigation Satellite System device (GNSS) (or corresponding interface circuitry, as discussed above), such as a Global Positioning System (GPS) device. The GNSS device 1718 may be in communication with a satellite-based system and may determine a geolocation of the electrical device 1700 based on information received from one or more GNSS satellites, as known in the art.

The electrical device 1700 may include another output device 1710 (or corresponding interface circuitry, as discussed above). Examples of the other output device 1710 may include an audio codec, a video codec, a printer, a wired or wireless transmitter for providing information to other devices, or an additional storage device.

The electrical device 1700 may include another input device 1720 (or corresponding interface circuitry, as discussed above). Examples of the other input device 1720 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.
The electrical device 1700 may have any form factor, such as a hand-held or mobile electrical device (e.g., a cell phone, a smartphone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console), a desktop electrical device, a server, a rack-level computing solution (e.g., blade, tray, or sled computing system), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1700 may be any other electronic device that processes data. In some embodiments, the electrical device 1700 may comprise multiple discrete physical components. Given the range of devices that the electrical device 1700 can be manifested as in various embodiments, in some embodiments, the electrical device 1700 can be referred to as a computing device or a computing system.

### EXAMPLES

Illustrative examples of the technologies disclosed herein are provided below. An embodiment of the technologies may include any one or more, and any combination of, the examples described below.

Example 1 includes a system comprising a quantum processor, wherein the quantum processor, in operation, comprises a plurality of spin qubits; a pulse generator; and calibration circuitry to (i) select a spin qubit of the plurality of spin qubits for calibration; (ii) determine a filter parameter associated with the spin qubit; (iii) generate a pulse from the pulse generator based on the filter parameter; (iv) provide the pulse to the spin qubit; (v) determine a state of the spin qubit; (vi) update the filter parameter based on the state of the spin qubit; and (vii) repeat steps (iii)-(vi) one or more times.

Example 2 includes the subject matter of Example 1, and wherein the calibration circuitry is to update the filter parameter by increasing the filter parameter by a pre-determined amount when the state of the spin qubit is a first value and decreasing the filter parameter by the pre-determined amount when the state of the spin qubit is a second value.

Example 3 includes the subject matter of any of Examples 1 and 2, and further including an integrated circuit, the integrated circuit comprising the calibration circuitry, wherein the integrated circuit is in a cryogenic stage of a cryogenic refrigerator.

Example 4 includes the subject matter of any of Examples 1-3, and wherein the filter parameter is a parameter of a variable gain filter.

Example 5 includes the subject matter of any of Examples 1-4, and wherein the filter parameter is a filter of a finite impulse response (FIR) filter.

Example 6 includes the subject matter of any of Examples 1-5, and wherein the filter parameter is a filter of an infinite impulse response (IIR) filter.

Example 7 includes the subject matter of any of Examples 1-6, and wherein the calibration circuitry is to calibrate a filter parameter associated with a first qubit and a second filter parameter associated with a second qubit simultaneously.

Example 8 includes the subject matter of any of Examples 1-7, and wherein the calibration circuitry comprises an analog integrator, wherein to update the filter parameter based on the state of the spin qubit comprises to update a voltage on the analog integrator.

Example 9 includes the subject matter of any of Examples 1-8, and further including multiplexing circuitry to connect the calibration circuitry to any of the plurality of spin qubits.

Example 10 includes the subject matter of any of Examples 1-9, and wherein the calibration circuitry is to determine a control gain parameter, wherein to update the filter parameter based on the state of the spin qubit comprises to update the filter parameter based control gain parameter, wherein the control circuitry is to update the control gain parameter based on an error value associated with the updated filter parameter.

Example 11 includes the subject matter of any of Examples 1-10, and wherein the pulse from the pulse generator is a radio-frequency (RF) pulse, wherein the filter parameter indicates a frequency of the RF pulse.

Example 12 includes the subject matter of any of Examples 1-11, and wherein the pulse from the pulse generator is a voltage pulse, wherein the filter parameter indicates an amplitude of the voltage pulse.

Example 13 includes the subject matter of any of Examples 1-12, and wherein the pulse from the pulse generator is a voltage pulse, wherein the filter parameter indicates a duration of the voltage pulse.

Example 14 includes the subject matter of any of Examples 1-13, and further including quantum/classical interface circuitry, the quantum/classical interface circuitry to move one or more logical qubits from the spin qubit before calibration of the spin qubit; and perform one or more operations on the quantum processor while the calibration circuitry calibrates the pulse from the pulse generator for the spin qubit.

Example 15 includes the subject matter of any of Examples 1-14, and further including quantum/classical interface circuitry; a cryogenic refrigerator, wherein the quantum/classical interface circuitry is at least partially within the cryogenic refrigerator, wherein the quantum processor is within the cryogenic refrigerator; and a classical processor outside of the cryogenic refrigerator, the classical processor coupled to the quantum/classical interface circuitry.

Example 16 includes a system comprising a quantum processor, wherein the quantum processor, in operation, comprises a plurality of spin qubits; a pulse generator; and calibration circuitry to continuously calibrate a pulse from the pulse generator, wherein to continuously calibrate the pulse from the pulse generator comprises to determine a filter parameter associated with a spin qubit of the plurality of spin qubits; generate a pulse from the pulse generator based on the filter parameter; provide the pulse to the spin qubit; determine a state of the spin qubit; and update the filter parameter based on the state of the spin qubit.

Example 17 includes the subject matter of Example 16, and wherein the calibration circuitry is to update the filter parameter by increasing the filter parameter by a pre-determined amount when the state of the spin qubit is a first value and decreasing the filter parameter by the pre-determined amount when the state of the spin qubit is a second value.

Example 18 includes the subject matter of any of Examples 16 and 17, and further including an integrated circuit, the integrated circuit comprising the calibration circuitry, wherein the integrated circuit is in a cryogenic stage of a cryogenic refrigerator.

Example 19 includes the subject matter of any of Examples 16-18, and wherein the filter parameter is a parameter of a variable gain filter.

Example 20 includes the subject matter of any of Examples 16-19, and wherein the filter parameter is a filter of a finite impulse response (FIR) filter.

Example 21 includes the subject matter of any of Examples 16-20, and wherein the filter parameter is a filter of an infinite impulse response (IIR) filter.

Example 22 includes the subject matter of any of Examples 16-21, and wherein the calibration circuitry is to calibrate a filter parameter associated with a first qubit and a second filter parameter associated with a second qubit simultaneously.

Example 23 includes the subject matter of any of Examples 16-22, and wherein the calibration circuitry comprises an analog integrator, wherein to update the filter parameter based on the state of the spin qubit comprises to update a voltage on the analog integrator.

Example 24 includes the subject matter of any of Examples 16-23, and further including multiplexing circuitry to connect the calibration circuitry to any of the plurality of spin qubits.

Example 25 includes the subject matter of any of Examples 16-24, and wherein the calibration circuitry is to determine a control gain parameter, wherein to update the filter parameter based on the state of the spin qubit comprises to update the filter parameter based control gain parameter, wherein the control circuitry is to update the control gain parameter based on an error value associated with the updated filter parameter.

Example 26 includes the subject matter of any of Examples 16-25, and wherein the pulse from the pulse generator is a radio-frequency (RF) pulse, wherein the filter parameter indicates a frequency of the RF pulse.

Example 27 includes the subject matter of any of Examples 16-26, and wherein the pulse from the pulse generator is a voltage pulse, wherein the filter parameter indicates an amplitude of the voltage pulse.

Example 28 includes the subject matter of any of Examples 16-27, and wherein the pulse from the pulse generator is a voltage pulse, wherein the filter parameter indicates a duration of the voltage pulse.

Example 29 includes the subject matter of any of Examples 16-28, and further including quantum/classical interface circuitry, the quantum/classical interface circuitry to move one or more logical qubits from the spin qubit before calibration of the spin qubit; and perform one or more operations on the quantum processor while the calibration circuitry calibrates pulse from the pulse generator for the spin qubit.

Example 30 includes the subject matter of any of Examples 16-29, and further including quantum/classical interface circuitry; a cryogenic refrigerator, wherein the quantum/classical interface circuitry is at least partially within the cryogenic refrigerator, wherein the quantum processor is within the cryogenic refrigerator; and a classical processor outside of the cryogenic refrigerator, the classical processor coupled to the quantum/classical interface circuitry.

Example 31 includes a system comprising a quantum processor, wherein the quantum processor, in operation, comprises a plurality of spin qubits; a pulse generator; and means for continuously calibrating a pulse from the pulse generator to control a spin qubit of the plurality of spin qubits.

Example 32 includes the subject matter of Example 31, and wherein the means for continuously calibrating the pulse from the pulse generator comprises means for updating a filter parameter by increasing the filter parameter by a pre-determined amount when a state of the spin qubit is a first value and decreasing the filter parameter by the pre-determined amount when the state of the spin qubit is a second value.

Example 33 includes the subject matter of any of Examples 31 and 32, and wherein the filter parameter is a parameter of a variable gain filter.

Example 34 includes the subject matter of any of Examples 31-33, and wherein the filter parameter is a filter of a finite impulse response (FIR) filter.

Example 35 includes the subject matter of any of Examples 31-34, and wherein the filter parameter is a filter of an infinite impulse response (IIR) filter.

Example 36 includes the subject matter of any of Examples 31-35, and wherein the means for continuously calibrating the pulse from the pulse generator is to determine a control gain parameter, wherein updating the filter parameter comprises updating the filter parameter based on the control gain parameter, wherein the means for continuously calibrating the pulse from the pulse generator is to update the control gain parameter based on an error value associated with the updated filter parameter.

Example 37 includes the subject matter of any of Examples 31-36, and wherein the means for continuously calibrating the pulse from the pulse generator comprises an analog integrator, wherein updating the filter parameter based on the state of the spin qubit comprises to update a voltage on the analog integrator.

Example 38 includes the subject matter of any of Examples 31-37, and further including an integrated circuit, the integrated circuit comprising the means for continuously calibrating the pulse from the pulse generator, wherein the integrated circuit is in a cryogenic stage of a cryogenic refrigerator.

Example 39 includes the subject matter of any of Examples 31-38, and wherein the means for continuously calibrating the pulse from the pulse generator is to calibrate a filter parameter associated with a first qubit and a second filter parameter associated with a second qubit simultaneously.

Example 40 includes the subject matter of any of Examples 31-39, and further including multiplexing circuitry to connect the means for continuously calibrating the pulse from the pulse generator to any of the plurality of spin qubits.

Example 41 includes the subject matter of any of Examples 31-40, and wherein the pulse from the pulse generator is a radio-frequency (RF) pulse, wherein the means for continuously calibrating the pulse from the pulse generator is to indicate a frequency of the RF pulse.

Example 42 includes the subject matter of any of Examples 31-41, and wherein the pulse from the pulse generator is a voltage pulse, wherein the means for continuously calibrating the pulse from the pulse generator is to indicate an amplitude of the voltage pulse.

Example 43 includes the subject matter of any of Examples 31-42, and wherein the pulse from the pulse generator is a voltage pulse, wherein the means for continuously calibrating the pulse from the pulse generator is to indicate a duration of the voltage pulse.

Example 44 includes the subject matter of any of Examples 31-43, and further including quantum/classical interface circuitry, the quantum/classical interface circuitry to move one or more logical qubits from the spin qubit before calibration of the spin qubit; and perform one or more operations on the quantum processor while the means for continuously calibrating the pulse from the pulse generator calibrates the pulse.

Example 45 includes the subject matter of any of Examples 31-44, and further including quantum/classical interface circuitry; a cryogenic refrigerator, wherein the quantum/classical interface circuitry is at least partially within the cryogenic refrigerator, wherein the quantum processor is within the cryogenic refrigerator; and a classical processor outside of the cryogenic refrigerator, the classical processor coupled to the quantum/classical interface circuitry.

## Claims

1. A system comprising:
a quantum processor, wherein the quantum processor, in operation, comprises a plurality of spin qubits;
a pulse generator; and
calibration circuitry to:
(i) select a spin qubit of the plurality of spin qubits for calibration;
(ii) determine a filter parameter associated with the spin qubit;
(iii) generate a pulse from the pulse generator based on the filter parameter;
(iv) provide the pulse to the spin qubit;
(v) determine a state of the spin qubit;
(vi) update the filter parameter based on the state of the spin qubit; and
(vii) repeat steps (iii)-(vi) one or more times.

2. The system of claim 1, wherein the calibration circuitry is to update the filter parameter by increasing the filter parameter by a pre-determined amount when the state of the spin qubit is a first value and decreasing the filter parameter by the pre-determined amount when the state of the spin qubit is a second value.

3. The system of claim 1 or claim 2, further comprising an integrated circuit, the integrated circuit comprising the calibration circuitry, wherein the integrated circuit is in a cryogenic stage of a cryogenic refrigerator.

4. The system of any of claims 1 to 3, wherein the filter parameter is a parameter of a variable gain filter.

5. The system of any of claims 1 to 4, wherein the filter parameter is a filter of a finite impulse response (FIR) filter.

6. The system of any of claims 1 to 5, wherein the filter parameter is a filter of an infinite impulse response (IIR) filter.

7. The system of any of claims 1 to 6, wherein the calibration circuitry is to calibrate a filter parameter associated with a first qubit and a second filter parameter associated with a second qubit simultaneously.

8. The system of any of claims 1 to 7, wherein the calibration circuitry comprises an analog integrator, wherein to update the filter parameter based on the state of the spin qubit comprises to update a voltage on the analog integrator.

9. The system of any of claims 1 to 8, further comprising multiplexing circuitry to connect the calibration circuitry to any of the plurality of spin qubits.

10. The system of any of claims 1 to 9, wherein the calibration circuitry is to determine a control gain parameter, wherein to update the filter parameter based on the state of the spin qubit comprises to update the filter parameter based control gain parameter, wherein the control circuitry is to update the control gain parameter based on an error value associated with the updated filter parameter.

11. The system of any of claims 1 to 10, wherein the pulse from the pulse generator is a radio-frequency (RF) pulse, wherein the filter parameter indicates a frequency of the RF pulse.

12. The system of any of claims 1 to 11, wherein the pulse from the pulse generator is a voltage pulse, wherein the filter parameter indicates an amplitude of the voltage pulse.

13. The system of any of claims 1 to 12, wherein the pulse from the pulse generator is a voltage pulse, wherein the filter parameter indicates a duration of the voltage pulse.

14. The system of any of claims 1 to 13, further comprising quantum/classical interface circuitry, the quantum/classical interface circuitry to:
move one or more logical qubits from the spin qubit before calibration of the spin qubit; and
perform one or more operations on the quantum processor while the calibration circuitry calibrates the pulse from the pulse generator for the spin qubit.

15. The system of any of claims 1 to 14, further comprising:
quantum/classical interface circuitry;
a cryogenic refrigerator, wherein the quantum/classical interface circuitry is at least partially within the cryogenic refrigerator, wherein the quantum processor is within the cryogenic refrigerator; and
a classical processor outside of the cryogenic refrigerator, the classical processor coupled to the quantum/classical interface circuitry.
